# EUROPÄISCHE PATENTSCHRIFT

(11) **EP 0 812 479 B1**
(45) Veröffentlichungstag und Bekanntmachung des Hinweises auf die Patenterteilung: **20.01.1999**
(21) Anmeldenummer: 96904708.3
(22) Anmeldetag: 24.02.1996
(51) Int. Cl.: H01L 39/22

(54) **SUPRALEITENDE TUNNELELEMENTE, DARAUS HERGESTELLE TUNNELSTAPEL SOWIE DEREN VERWENDUNG**
SUPERCONDUCTIVE TUNNEL ELEMENTS, STACK OF TUNNEL ELEMENTS AND THEIR USE
ELEMENTS TUNNEL SUPRACONDUCTEURS, PILES D'ELEMENTS TUNNEL ET LEUR UTILISATION

(30) Priorität: 01.03.1995 DE 19507024
(43) Veröffentlichungstag der Anmeldung: 17.12.1997
(73) Patentinhaber: Schröder, Hehrwart, 88662 Überlingen (DE)
(72) Erfinder: Schröder, Hehrwart, 88662 Überlingen (DE)
(74) Vertreter: Patentanwälte Eisele, Otten & Roth
(86) Internationale Anmeldenummer: DE9600310
(87) Internationale Veröffentlichungsnummer: WO9627214

(56) Entgegenhaltungen:
- EP-A- 0 513 557

## Beschreibung

Die Erfindung betrifft supraleitende Tunnelelemente, daraus hergestellte Tunnelstapel sowie deren Verwendung.

In der EP 0 513 557 A2 sind supraleitende Tunnelelemente, daraus hergestellte Tunnelstapel sowie darauf beruhende Verwendungen bekannt. Diese Tunnelelemente haben den Aufbau Supraleiter, Tunnelbarriere, Supraleiter, wobei innerhalb der beiden Supraleiter jeweils eine isolierte supraleitende steuerschicht vorhanden ist. Durch diese Anordnung wird eine gleichmäßige und homogene Durchflutung der Supraleiter mit den strominduzierten Magnetfeldern der Steuerschichten erreicht, so daß die Energielücke der Supraleiter sehr genau gesteuert werden kann. Der symmetrische Aufbau dieses Elements ermöglicht außerdem eine unproblematische Integration mehrerer Elemente zu einem Tunnelstapel, indem abwechselnd Supraleiter und Barrieren fortlaufend übereinander angeordnet werden. Nachteilig an dieser Vorrichtung ist jedoch, daß eine große Anzahl von Einzelschichten vorhanden sind. So besteht ein Supraleiter bereits aus 5 Einzelschichten (eine Steuerschicht, zwei isolationsschichten zur Isolierung der Steuerschicht, sowie zwei supraleitende Schichten). Entsprechend ist die Herstellung dieser Tunnelzellen sehr aufwendig und teuer.

Aufgabe der Erfindung ist es deshalb, ein Tunnelelement anzugeben, das gegenüber der EP 0 513 557 A2 eine größere Vielfalt der Anwendungsmöglichkeiten eröffnet.

Diese Aufgabe wird durch ein Tunnelelement mit den Merkmalen des Anspruchs 1 gelöst. Die Ansprüche 2 bis 8 geben vorteilhaft ausgestaltete und vorteilhaft geschaltete Tunnelelemente wieder. Die Unteransprüche 9 bis 12 geben aus den neuen Tunnelelementen hergestellte vorteilhafte Tunnelstapel an. Die Ansprüche 13 bis 16 betreffen Anwendungen der Tunnelelemente.

Nachstehend wird die Erfindung anhand von Beispielen und Ausführungsbeispielen von Tunnelelementen, deren Schaltungen sowie von Tunnelstapeln und deren Verwendung näher erläutert (Die Figuren 1, 4, 5, 8, 11, 12, 14 und 15 zeigen Tunnelelemente ohne erfindungsgemäße Proximity-Schicht.):

Es zeigt:
- Fig. 1: ein Tunnelelement mit Schaltschema,
- Fig. 2: eine Variante eines Tunnelelements mit Schaltschema,
- Fig. 3: eine weitere Variante eines Tunnelelements mit Schaltschema,
- Fig. 4: eine weitere variante eines Tunnelelements für Rechner-Schaltungen mit Schaltschema,
- Fig. 5 bis 8: jeweils einen Tunnelstapel aus einzelnen Tunnelelementen mit Schaltschema
- Fig. 9: ein Tunnelstapelfeld auf einem substratquader,
- Fig. 10: eine digitale supraleitungselektronische Kamera im schwenkbaren Dewar mit Cassegrain-Spiegelsystem in schematischer Darstellung,
- Fig. 11: einen supraleitungselektronischen kohärenten Strahler mit normalen Spiegeln,
- Fig. 12: einen supraleitungs elektronischen kohärenten Strahler mit phasenkonjugierten Spiegeln und mit Frequenzvervielfachung,
- Fig. 13: eine supraleitungselektronische Strahlenpinzette in schematischer Darstellung,
- Fig. 14: ein RF-SQUID auf Tunnelstapelbasis in schematischer Darstellung,
- Fig. 15: ein DC-SQUID auf Tunnelstapelbasis in schematischer Darstellung,
- Fig. 16: ein DC-SQUID-Achsen-Feld in schematischer Darstellung,
- Fig. 17: ein Schaltschema eines quantenmechanisches Interferenz-Systems.

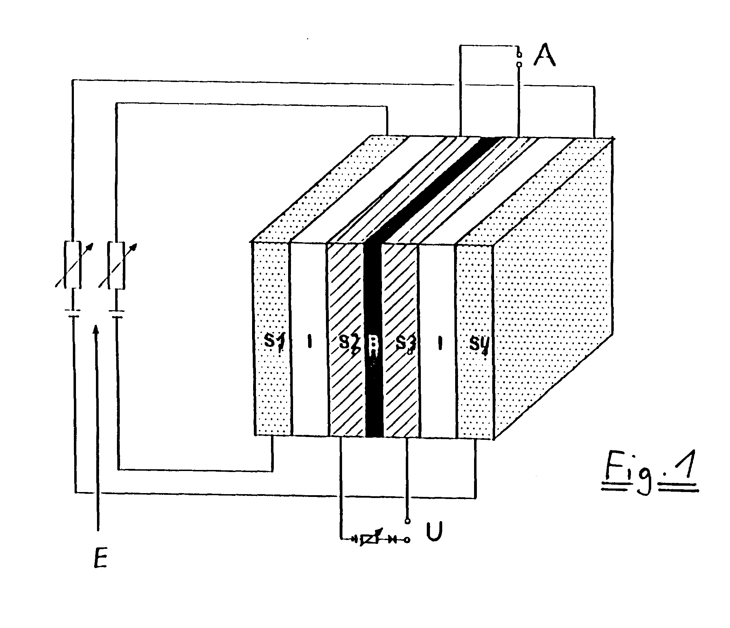

Das in Fig. 1 dargestellte Tunnelelement weist folgenden symmetrischen Schichtaufbau auf. Beiderseits auf einer schichtförmigen Barriere B sind schichtförmige Supraleiter S2 und S3 angeordnet, auf deren freien Oberflächen schichtförmige Isolatoren I und darauf schichtförmige Supraleiter S1 und S4 angeordnet sind. Jeder Supraleiter S1 bis S4 weist individuelle supraleitende Anschlüsse auf. Die Supraleiter S2 und S3 sind supraleitende Tunnelschichten und an eine regelbare Signalstromquelle A sowie an eine Steuerung der Arbeitsspannung U angeschlossen, in dem Schaltkreis der letzteren ist eine Tunneldiode oder ein Transistor geschaltet.
Die Supraleiter S1 und S4 dienen als supraleitende Steuerschichten zur Energielückensteuerung E. Die strom induzierten Felder durchfluten jeweils gleichmäßig das gesamte Volumen der supraleitenden Schichten S2 und S3. Der hier gezeigte Schichtaufbau ist die dichtest mögliche Packung, die noch das Prinzip der individuellen Steuerung durch die beiden supraleitenden Steuerschichten erfüllen kann. Die Fertigung ist wegen der geringen Anzahl der einzelnen Schichten relativ wenig aufwendig, was sich insbesondere bei einem Stapel aus einer großen Anzahl einzelner Tunnelelemente auswirkt.

Der Begriff Barrieren bzw. Tunnelbarrieren ist in der vorliegenden Anmeldung so zu verstehen, daß durch derartige Schichten eine Tunneln erlaubt sein soll. Demgegenüber ist der Begriff Isolatoren so zu verstehen, daß durch diese Schichten ein Tunneln in jedem Fall vermieden werden soll. Dem Fachmann ist bekannt, daß dieser Unterschied insbesondere durch eine entsprechende Wahl der Schichtdicken erreicht werden kann. Isolatoren haben typischer weise eine Dicke von größer oder gleich 5 nm. Barrieren haben bevorzugt eine Dicke von unter 5 nm, insbesondere 1 bis 1,5 nm.

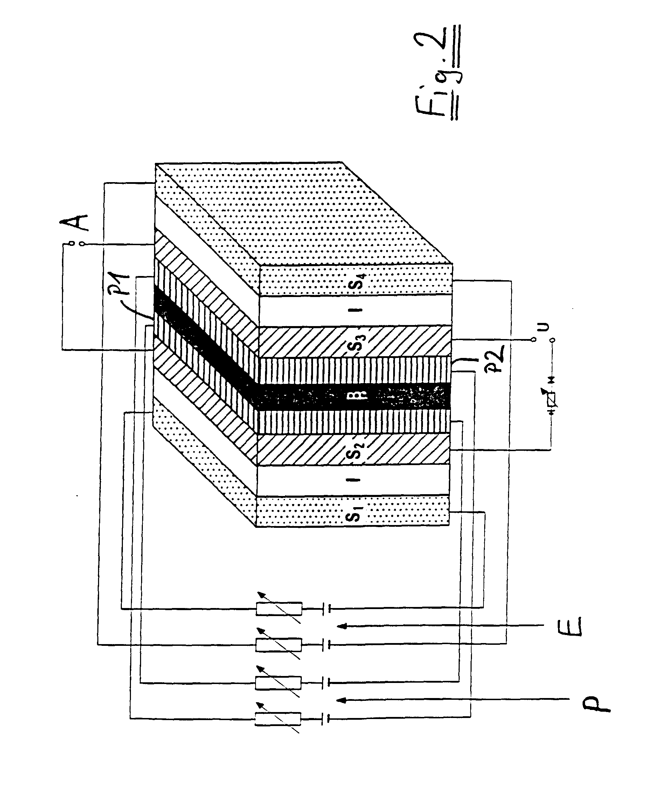

Aus dem Tunnelelement gemäß Fig. 1 wird erfindungsgemäß ein sogenanntes Proximity-Tunnelelement hergestellt. Dieses ist in Fig. 2 dargestellt. Hierbei ist zwischen der zentralen Barriere B und den benachbarten, als Tunnelschicht dienenden Supraleiter S2 bzw. S3, jeweils eine normal leitende oder halbleitende Schicht oder eine supraleitende Schicht P1, P2 mit einer gegenüber den Energielücken der Tunnelschichten S2, S3 kleineren Energielücke vorgesehen. Die Schaltung eines solchen Tunnelelements bleibt bis auf die Steuerung P der Proximity-Schichten P1, P2 unverändert und ist so ausgeführt, wie sie in Fig. 1 dargestellt ist. Die Proximity-Einflüsse reichen von den supraleitenden Schichten in den angrenzenden Normalleiter und umgekehrt mit einer Reichweite, die der Kohärenzlänge entspricht. Im Ergebnis wird der Normalleiter supraleitend und beim Supraleiter sinkt die kritische Temperatur. Der Proximity-Tunneleffekt wird durch die zwischengeschaltete Schicht zwischen Barriere und Supraleiter hervorgerufen. Diese Zwischenschichten weisen typischerweise Dicken bis zu 2 nm auf. Die Tunnelzustandsdichte ändert sich in einer

Proximity-Tunnelschaltung deutlich. Die Proximity-Tunnelzelle ermöglicht es, über mesoskopische Quantenphänomene die supraleitungselektronischen Anwendungen auszudehnen. Besondere Anwendungsgebiete sind die Detektion von Röntgen- und Gammastrahlen, beispielsweise über photonenun-terstützte Tunnelprozesse.

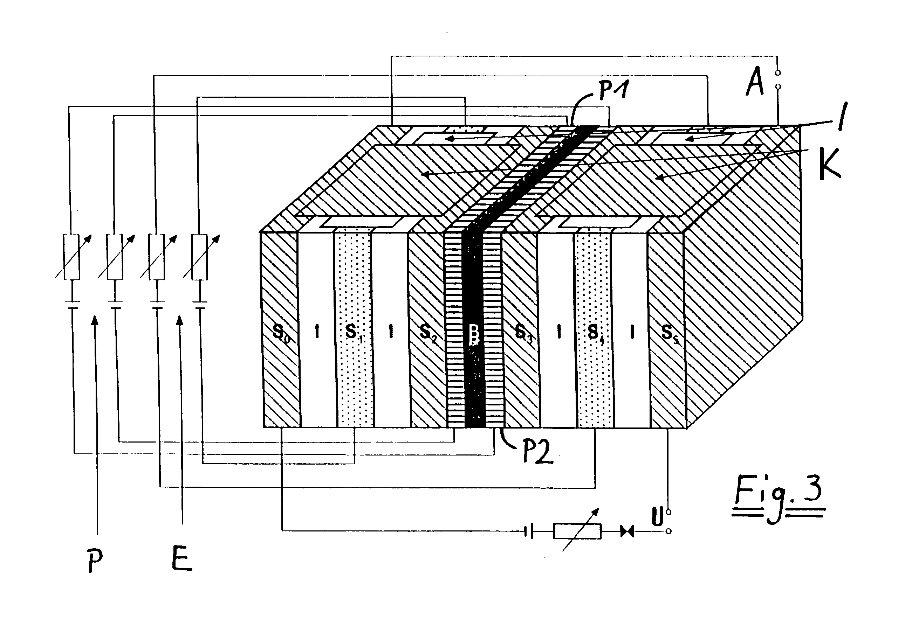

Proximity-Effekte können auch in der in Fig. 3 dargestellten Ausbildung eines Tunnelstapels genutzt werden. Zwischen der zentralen Barriere B und den benachbarten, als Tunnelschicht dienenden Supraleitern S2 bzw S3 ist jeweils eine normal leitende oder halbleitende Schicht oder eine supraleitende Schicht P1,P2 mit kleiner Energielücke vorgesehen. Dieses Tunnelelement weist im übrigen den gleichen Grundaufbau wie das in Fig. 1 gezeigte Tunnelelement auf, es sind lediglich jeweils auf den aussen liegenden Supraleitern S1 bzw. S4 zusätzlich Schichten in Form eines Isolators I und eines weiteren Supraleiters S0 bzw. S5 vorhanden. Bei diesem Tunnelelement sind die als Steuerschichten dienenden Supraleiter S1, S4 zwischen zwei als Tunnelschichten dienenden Supraleitern S0, S2 bzw. S3, S5 angeordnet, wodurch ein besonders symmetrischer Aufbau und homogene Felder erzielt werden. Die strom induzierten Felder durchfluten die supraleitenden Schichten S0, S2 bzw. S3, S5 von der Mitte her, was besonders vorteilhaft für die volle Steuerfähigkeit des Tunnelelements ist. Auch hier sind alle Supraleiter S0 bis S6 mit individuellen supraleitenden Anschlüssen versehen. Daraus folgt eine große Anzahl möglicher sinnvoller Kombinationen elektronischer Schaltungen, wobei es nicht nur um kombinatorische Schaltungen mit supraleitenden Schichten, sondern auch um die Größen von Gleich- und Wechselspannungen und Frequenzen von Wechselspannungen geht. Da die Steuerung zentral erfolgt, kann ein besonders homogenes Feld aufgebaut werden.

Vorzugsweise sind die als Tunnelschichten dienenden Supraleiter S0, S2 bzw. S3, S5 beiderseits der Barriere B über eine Kurzschlußbrücke K verbunden, die vorzugsweise ebenfalls supraleitend ausgebildet ist. Jede Kurzschlußbrücke K ist durch einen schichtförmigen Isolator I von dem jeweiligen als Steuerschicht dienenden Supraleiter S1 bzw. S4 getrennt. Die Schaltung dieses Elements entspricht der in Fig. 1 und Fig. 2 dargestellten und wird daher nicht mehr erläutert.

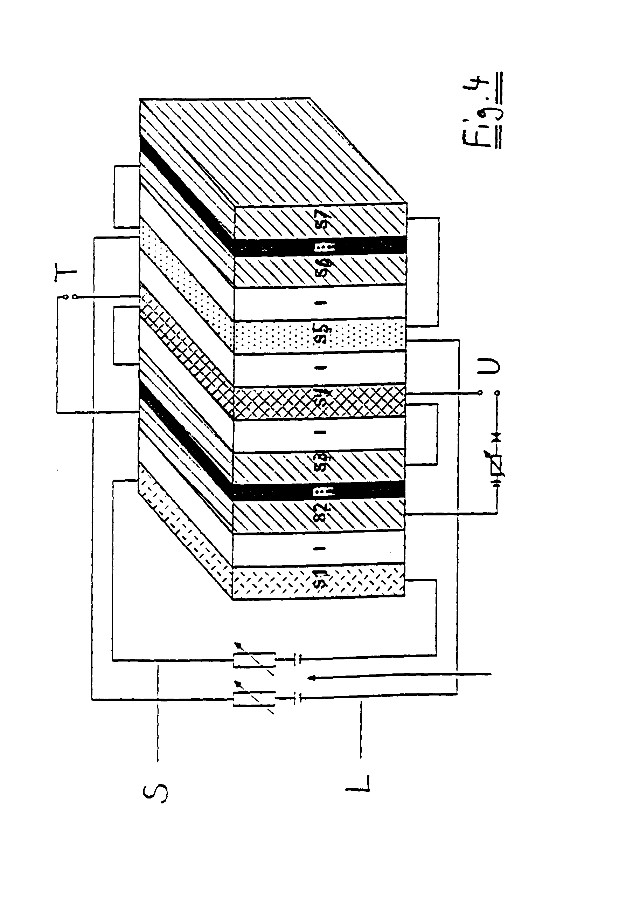

Fig. 4 zeigt ein Tunnelelement zur Umsetzung des Speicherprinzips von Juri Matisoo für Rechnerschaltungen (Juri Matisoo, Josephson Computer Technology, LT15, Seiten 1590 bis 1597, (1978)). Dieses Tunnelelement geht von einem grundsätzlichen Aufbau aus, wie es in Fig. 1 beschrieben ist, d.h. es sind beiderseits einer Barriere B durch Isolatoren I getrennte Supraleiter S1 und S2, bzw. S3 und S4 vorhanden. Neu ist, daß sich an einer Seite zusätzliche Schichten: ein Isolator I, ein Supraleiter S5, ein weiterer Isolator I, ein weiterer Supraleiter S6, ein zusätzliche Barriere B sowie ein weiterer Supraleiter S7 anschließen. Bei dieser Ausführung des Tunnelelements sind die Supraleiter S2 und S3 die Tunnelschichten, der Supraleiter S1 wird zur Schreibleitung, der Supraleiter S4 wird Teil einer Tunnelschleife, der Supraleiter S5 dient als Leseleitung, wobei die Leseleitung S5 mit dem Josephson-Kontakt aus Supraleiter S6, zusätzlicher Barriere B und Supraleiter S7 einen Stromkreis bildet. Alle zusammen stellen die Speicherzelle für "binär 0" bzw. "binär 1" dar. In Fig. 4 ist eine Schaltung dargestellt, wobei mit T der Tunnelstrom, mit S die Schreibleitung, mit L die Leseleitung und mit U die Arbeitsspannunssteuerung bezeichnet sind, wobei in den Schaltkreis der Arbeitsspannungssteuerung eine Tunneldiode ein oder ein Transistor geschaltet sind.

In der Funktion "Schreiben" liegt über der Tunnelschleife als Steuerleitung die Schreibleitung. Unter der Tunnelschleife liegt als Steuerleitung die Leseleitung. Wenn man gleichzeitig Ströme durch die Schreibleitung schickt, geht der Tunnelkontakt der Tunnelschleife in den normalleitenden Zustand über und drängt den Schleifenstrom in den anderen Schleifenzweig. Wenn beide Ströme abgeschaltet werden, wird der Kontakt wieder supraleitend, und das Magnetfeld induziert eine "binäre 1". Um den Elementinhalt "binär 0" zu schreiben muß die Schreibleitung stromlos bleiben. Der Schleifenstrom fließt dann durch beide Zweige der Schleife ab und hebt sich in der Wirkung auf. Es entsteht deshalb kein Dauerstrom.

In der Funktion "Lesen" werden gleichzeitig Ströme durch die Tunnelschleife und durch die Leseleitung geschickt. Wenn das Element einen Dauerstrom enthält, fließt der zusätzliche Schleifenstrom durch den Zweig der Schleife, die den Tunnelkontakt der Leseleitung steuert. Der Kontakt der Leseleitung wird normalleitend und an seinem Ausgang erscheint ein Signal. Wenn die Tunnelschleife "binär 0" enthält, teilt sich der Schleifenstrom symmetrisch auf beide Zweige. Damit bleibt der Kontakt in der Leseleitung supraleitend und an seinem Ausgang erscheint kein Signal.

Jedes der beschriebenen Tunnelelemente kann zu einem Tunnelstapel zusammengesetzt werden, wobei jeweils zwischen zwei benachbarten Tumnelelementen Isolatoren oder Barrieren zur schaltungsmäßigen Abtrennung der einzelnen Tunnelelemente angeordnet sind.

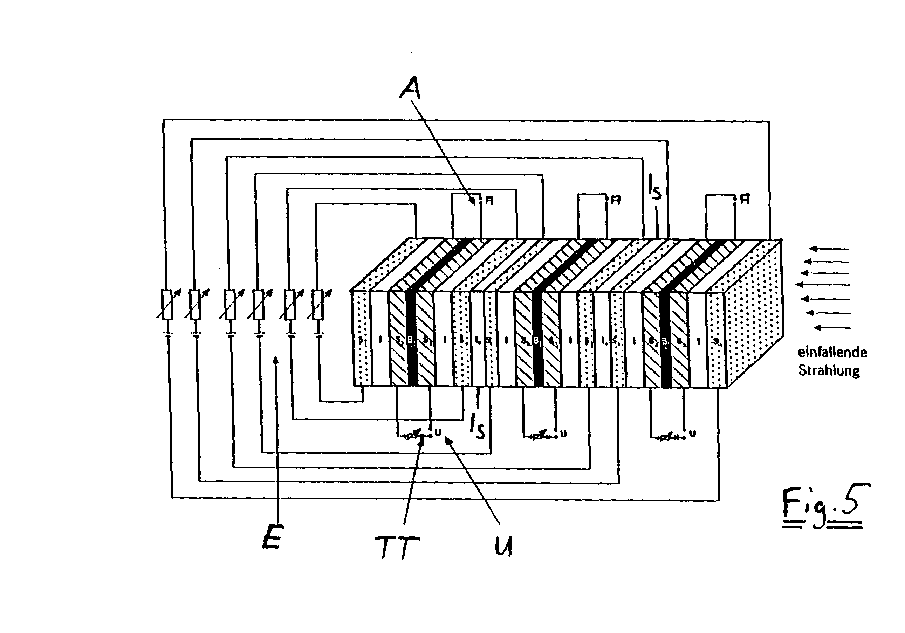

Fig. 5 zeigt einen Tunnelstapel aus drei einzelnen Tunnelelementen gemäß Fig. 1. Zwischen den Tunnelzellen sind Isolatoren l_{S} angeordnet, um parasitäre Tunnelprozesse zwischen supraleitenden Steuerschichten und supraleitenden Tunnelschichten zu unterbinden. Mit Bₜ sind die Tunnelbarrieren innerhalb einer einzelnen Tunnelzelle bezeichnet. Die übrigen Bezeichnungen der einzelnen Schichten entsprechen den in der Fig. 1 verwendeten. Die Steuerung der Intensität kann am nichtlinearen Teil der Kennlinie durch Steuerung des Tunnelstroms stufenlos und durch Abschaltung der einzelnen supraleitenden Tunnelzellen erfolgen. Die Energielücken der einzelnen Schichten können einheitlich und individuell von Null bis Maximum gesteuert werden.

Die in der Fig. 5 bis 8 angegebenen Bezugszeichen haben folgende Bedeutung:

| | |
|---|---|
| A | Signalstrom |
| E | Energielückensteuerung |
| TT | Tunneldiode oder Transistor |
| U | Arbeitsspannungssteuerung |
| K | supraleitende Kurzschlußbrücke |
| I | Isolierschichten für die Kurzschlußbrücken |
| T | Tunnelstrom |
| L | Leseleitung |
| S | Schreibleitung |

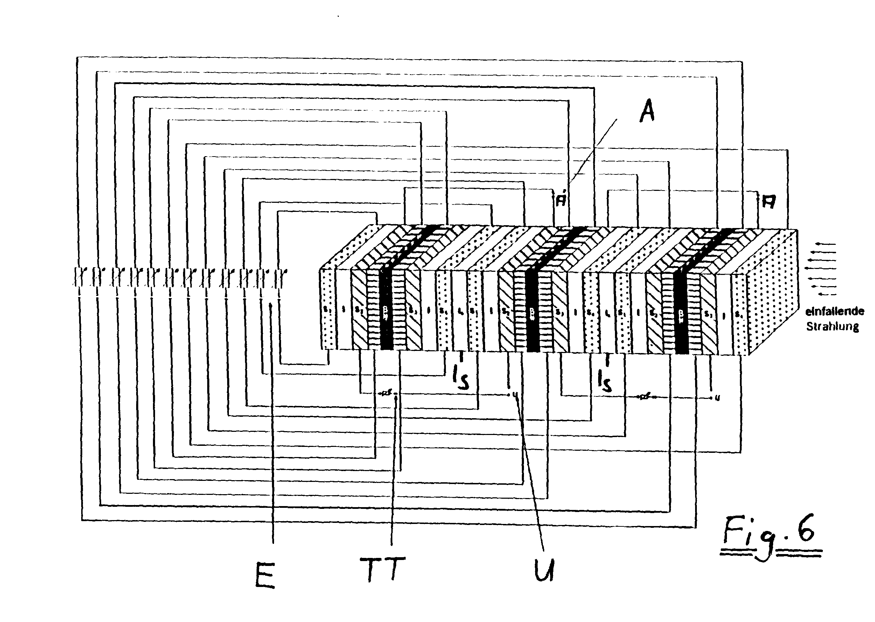

Fig. 6 zeigt einen Tunnelstapel aus drei einzelnen Tunnelelementen gemäß Fig. 2. Zwischen den Tunnelzellen sind Isolatoren l_{S} angeordnet.

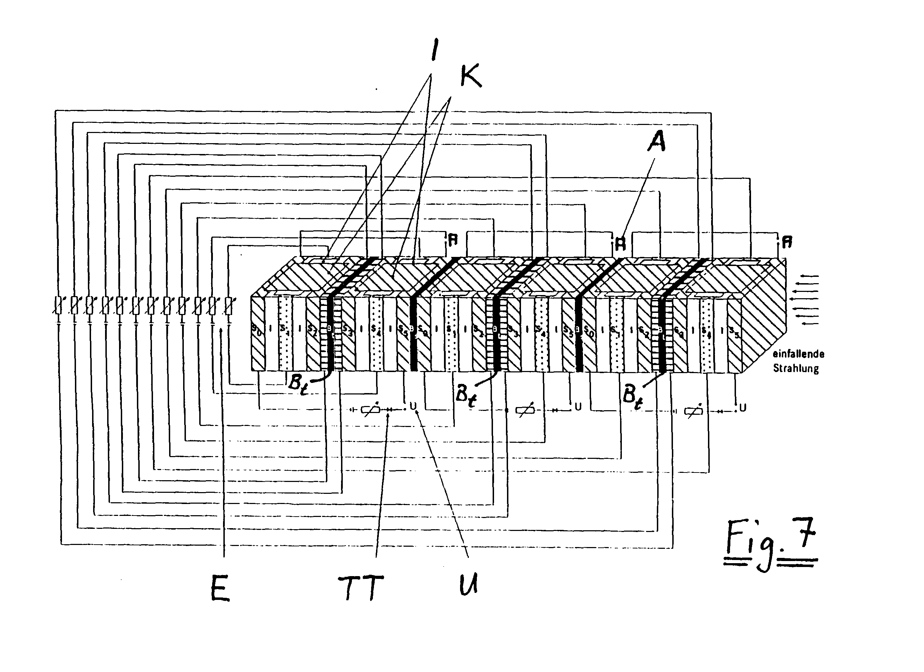

Fig. 7 zeigt einen Tunnelstapel aus drei einzelnen Tunnelelementen gemäß Fig. 3. Zwischen den Tunnelelementen sind Tunnelbarrieren Bₜ angeordnet.

In einer weiteren hier nicht gezeigten Ausführung können anstatt Tunnelbarrieren auch Isolatoren angeordnet sein.

Bei den Proximity-Stapeln gemäß Fig. 6 und 7 kommen weitere interessante Eigenschaften hinzu. Dies sind vor allem verschiedene Grenzflächeneffekte. Darüberhinaus werden Wechselwirkungen von Effekten verschiedener Anregungsmechanismen, sogenannte mesoskopische Phänomene auf der nm-Skala mit Grenzflächeneffekten und Tunnelprozessen technisch für verschiedene Detektionsmechanismen genutzt. Eine mögliche Anwendung ist eine Kamera für Röntgen- und Gammastrahlung.

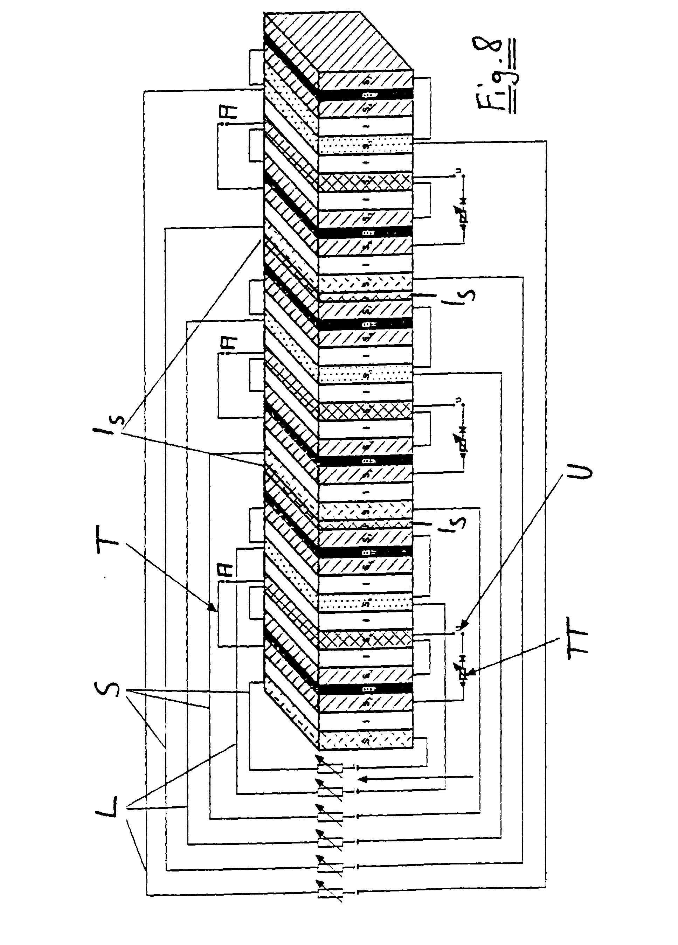

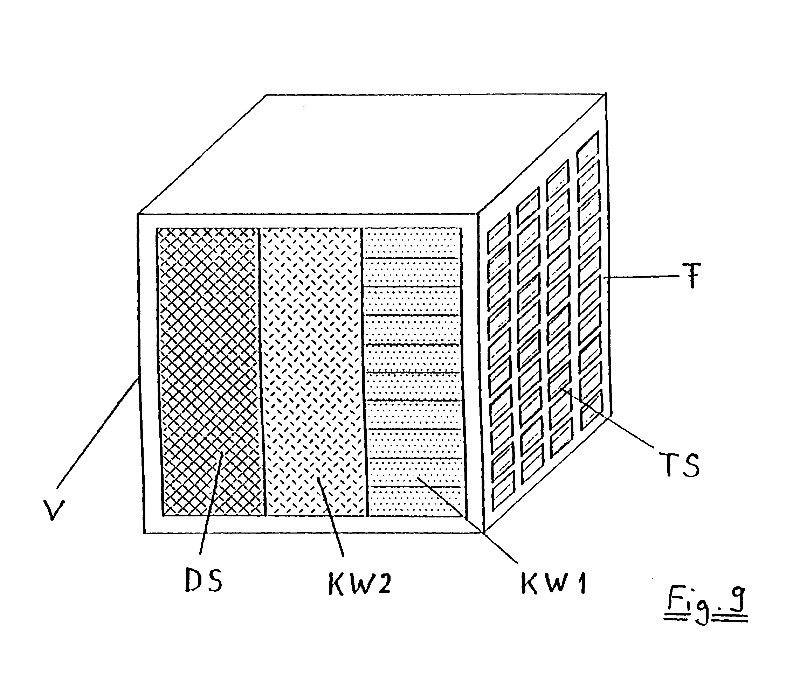

Fig. 8 zeigt einen Tunnelstapel aus drei einzelnen Tunnelelementen gemäß Fig. 4. Zwischen den Tunnelelementen sind Isolatoren Iₛ angeordnet. Mit derartigen Tunnelstapeln ist ein Datenspeicherung mit hoher Speicherdichte möglich. Typischerweise umfaßt ein solcher Stapel etwa 40.000 Tunnelelemente, wobei sich eine Stapelhöhe von ca. 2 Zentimeter ergibt. Bei einem Durchmesser eines Stapels (mit Isolierung) von ca. 1 µm sind auf einem Tunnelstapelfeld (siehe Fig. 9) von 2,5 cm Kantenlänge etwa 25 ∗ 10¹² Tunnelelemente vorhanden. Ein Tunnelelement speichert ein Bit, so daß der Speicher über ca. 3 Terabyte Speicherkapazität verfügt.

Da alle Supraleiter mit individuellen, vorzugsweise supraleitenden Anschlüssen versehen sind, ist eine beliebige sinnvolle Kombination elektronischer Schaltungen möglich, wobei unter Einsatz von Programmsteuerungen problemorientiert die beste mathematisch gefundene Schaltstruktur umgesetzt werden kann. Die dadurch sehr flexible Tunnelstapelschaltung wird dadurch zu einem überlegenen Instrument der Supraleitungselektronik. Grundsätzlich weisen Tunnelstapel gegenüber den einzelnen Tunnelzellen völlig andere Eigenschaften auf. Beispielsweise wächst mit jeder weiteren Tunnelzelle im Stapel die Strahlungsintensität des Tunnelstapels quadratisch an. Die im Tunnelstapelsystem wirksam werdende Selbstsynchronisation hat das praktische Ergebnis, daß die Linienbreite der Tunnel-Strahlung mit wachsender Tunnelzellenzahl immer schmaler wird.

Der Nachteil der kleinen Signalstärke bei allen supraleitenden Schaltungen wird durch eine ideale Reihenschaltung von Tunnelelementen im Stapel ausgeglichen. Wenn z.B. die Arbeitsspannung die Bedingung für den Detektionsmodus erfüllt, d.h. kleiner als 2 DELTA ist und alle Schichten mit gleichen Energielücken gesteuert werden, summiert sich mit jeder Schicht die Detektionsleistung abzüglich der Rauschleistung. Bei einem Detektor verbessert sich das Signal-Rausch-Verhältnis für das Nutzsignal proportional zu der Anahl der Schichtpaare. Mit einer Anzahl von n Tunnelelementen werden im Detektionsmodus n verschiedene Frequenzen gleichzeitig detektiert, wenn jedes n-te Tunnelelement verschiedene Energielücken aufweist. Die n verschiedenen Frequenzen können individuell eingestellt werden. Der Sensorstrom wächst proportional mit der Anzahl der einfallenden Photonen. Der Wirkungsgrad liegt sehr nahe bei Eins.

Wenn die Arbeitsspannung die Bedingung für den Sendemodus erfüllt, d.h. größer 2 DELTA ist, und alle Tunnelelemente mit gleicher Energielücke gesteuert werden, summiert sich mit jedem zusätzlichen Tunnelelement die Strahlungsintensität. Mit einer Anzahl n an Tunnelelementen werden im Sendemodus n verschiedene Frequenzen gleichzeitig gesendet, wenn alle Tunnelelemente verschiedene Energielücken aufweisen. Wegen der sehr geringen Ausgangsleistung eines Josephson-Elementes empfiehlt es sich, möglichst viele Tunnelelemente für die gewünschten Frequenzen zusammenzuschalten.

Da jedes Tunnelelement einzeln gesteuert werden kann, gibt es neben der Option "alle Tunnelelemente mit gleichen Energielücken" oder der Option "alle Tunnelelemente mit verschiedenen Energielücken " die Option "beliebige Kombinationen" zu schalten. So können z.B. eine beliebige Anzahl an Tunnelelementen für beliebig gewünschte Frequenzen zusammengefaßt werden, um die Detektionsleistung oder die Sendeintensität zu bündeln.

Supraleitende Tunnelelemente arbeiten bei einer definierten Arbeitsspannung als parametrischer Verstärker. Wegen der individuellen Steuerbarkeit jedes einzelnen Tunnelelements bietet es sich an, die Fähigkeit supraleitender Tunnelelemente, Signale parametrisch verstärken zu können, beispielsweise mit dem Detektormodus zu koppeln. Dabei werden ein oder mehrere Tunnelelemente, die auf der der Strahlung abgewandten Seite angeordnet sind, zum Verstärken verwendet.

Jedes einzelne Tunnelelement eignet sich auch als Schalter, weil es die erforderlichen Steuerleitungen als integrierte Steuerschichten aufweist. Mit den in den supraleitenden Steuerschichten erzeugten Magnetfeldern kann der Tunnelkontakt normal leitend oder supraleitend geschaltet werden. Für den Einsatz in Rechnern auf Supraleitungsbasis sind auch die zwei erforderlichen unabhängigen Steuerleitungen am Tunnelelement vorhanden.

Ein Tunnelstapel wird in Form eines heteroepitaktischen Übergitters hergestellt. Dazu wird zunächst das Material der Substratgrundplatte derart ausgewählt, daß es sich mit den zu verwendenden Materialien bezüglich der Gitterkonstanten verträgt. Auf der Substratgrundplatte kann wahlweise als Option ein Spiegel aus geeigneten Supraleitern gefertigt werden. Schichten ausreichender Dicke aus Supraleitern sind als Spiegel für einen besonders interessierenden Spektralbereich sehr viel leistungsfähiger, als konventionelle Spiegel. Der supraleitende Spiegel kann die Leistungen des Stapels verbessern. Auf dieser oben beschriebenen Unterlage kann dann der eigentliche Tunnelstapel gefertigt werden. Er besteht aus einer definierten Schichtfolge aus supraleitenden Schichten und Barrieren (dünne Isolatoren) bzw. Isolatoren (dicke Isolatoren).

Die beiden supraleitenden Tunnelschichten sind durch dünne Barrieren getrennt, um den Tunnelprozess zu ermöglichen. Die den supraleitenden Tunnelschichten benachbarten Steuerschichten sind durch eine Isolatorschicht isoliert, um störende Tunnelphänomene zu unterdrücken.

Die supraleitenden Schichten sollen so dünn sein, wie es die Funktionsfähigkeit der Supraleitung zuläßt. Beispielsweise ist das Material der Hochtemperatur-Supraleiter wegen der besonders kleinen Kohärenzlänge in der Grössenordnung nm noch supraleitend. Die Isolatoren an den Flanken der Steuersupraleiter müssen das Tunneln unterbinden und sind deshalb bevorzugt um 5 nm dick. Sie müssen so gewählt werden, daß sie möglichst durchlässig für die Strahlung sind. An die Barriere werden die höchsten Anforderungen gestellt. Sie müssen alle absolut dicht sein und sollen eine Dicke von 1 bis 1,5 nm haben. Die der Strahlung zugewandte Schichtfolge soll die Bedingung einer optisch dünnen Schicht erfüllen, d.h. die supraleitenden Schichten müssen viel kleiner als die Wellenlänge der Strahlung sein, mit der man arbeiten will. Die supraleitenden Schichten müssen mindestens die Dicke der materialspezifischen Kohärenzlänge erreichen. Das bedeutet, daß der ganze Stapel eine Dicke in der Größenordnung µm hat. Da die Schichten sehr dünn sind, ist auch der ganze Stapel nur eine dünne Folie.

Je kleiner die Oberfläche eines Tunnelkontaktes ist, desto besser ist er vor Fehlern gesichert. Für die angestrebten Sensorikziele muß die Tunnelfläche mindestens so groß sein, wie der Radius des ersten Beugungsringes des sogenannten Airy-Scheibchens der Arbeitswellenlänge. Da man aus vielen kleineren Flächen schaltungstechnisch nahezu jede gewünschte größere Fläche durch Zusammenschalten realisieren kann, kann man sich von der Energielückenabhängigen kurzwelligen Grenze an, die man nicht unterschreiten kann, jeder längeren Wellenlänge anpassen. Wenn ein einzelnes Tunnelelement mit 60 nm Dicke gefertigt würde, würde ein Tunnelstapel von beispielsweise 10.000 Tunnelelementen etwa 0,6 mm dick.

An den supraleitenden Tunnelschichten liegen die Anschlüsse für die ArbeitsSpannung und für den Signalstrom. Die in jeder supraleitenden Tunnelschicht von der Umgebung isoliert liegenden supraleitenden Steuerschichten sind an eine eigene Stromschleife angeschlossen. Dies wiederholt sich für alle Tunnelelemente eines Tunnelstapels. Weiter sollen zwei einander gegenüberliegende Flanken eines Stapels bevorzugt frei von Schaltkontakten bleiben. Damit soll gewährleistet werden, daß außer einer Einkopplung mittels optisch dünner Schichten auch die Einkopplung über die Flanke direkt in die Barriere offen bleibt.

Für die Arbeit eines Tunnelelementes muß eine Vorspannung an die beiderseits der Barriere liegende supraleitenden Tunnelschichten gelegt werden. Die Größe dieser Vorspannung entscheidet über die Betriebsart: Detektieren, parametrisch Verstärken oder Senden. Die Arbeitsvorspannung muß an die variabel gesteuerte Energielücke gekoppelt werden, uns sie muß mit einer Genauigkeit in der Größenordnung Nanovolt präzise gesteuert werden.

Eine stufenlose Steuerung der Intensität wird durch Steuerung des Tunnelstroms durchgeführt. Anstelle des Einsatzes supraleitender Bauelemente für die Steuerung kann z.B. eine Transistorschaltung in Reihe mit einer Präzisionsspannungsquelle geschaltet, diese Aufgabe erfüllen. Im linearen Kennlinienbereich kann ein linearer Widerstand die Arbeitsspannung steuern. Im nichtlinearen Kennlinienbereich ändert sich die Arbeitsspannung nur wenig, aber der Tunnelstrom steigt steil an. Wegen der nichtlinearen Kennlinienfelder des Transistors läßt sich damit ein geeignetes Steuerelement zum stufenlosen Steuern des Tunnelstroms realisieren.

Die Größe der Energielücke im Anregungsspektrum eines Supraleiters ist von der Temperatur, von der Größe des anliegenden elektromagnetischen Feldes und von der Größe des durchfließenden Stromes abhängig. Die Steuerung kann mittels Feldern oder mittels Temperaturen erfolgen.

Die Energielücken in supraleitenden Schichten können durch Einwirkung von elektromagnetischen Felder verändert und damit gesteuert werden. Die Magnetfelder werden in integrierten supraleitenden Steuerschichten erzeugt. Dabei muß das strominduzierte Steuerfeld homogen sein und gleichmäßig die supraleitende Schicht durchfluten. Dies ist auch ein Grund, daß die supraleitenden Schicht so dünn wie möglich sein sollen.

Die supraleitenden Steuerschichten können auch über die Temperatur gesteuert werden. Dies kann auf zwei verschiedenen Wegen erfolgen. Die eine Möglichkeit besteht darin, mit hochfrequenten Wechselspannungen an den Steuerschichten, die supraleitenden Tunnelschichten induktiv aufzuheizen. Die zweite Möglichkeit besteht darin, nach Überschreiten des kritischen Stromes in den Steuerschichten die Steuerschichten als Heizung zu verwenden. Die Tunnelschichten werden dann über den Wärmekontakt aufgeheizt. Wegen der sehr dünnen supraleitenden Schichten kann die sehr schlechte Wärmeleitung der Supraleiter vernachlässigt werden. Bei einer Energielückensteuerung über Temperaturänderungen liefern die nicht gebundenen Elektronen über sehr hohe Frequenzen Beiträge zur Temperaturerhöhung und führen deshalb zu einer Absenkung des kritischen Stromes. Die Energielückensteuerung über die Temperatur läßt schärfere Frequenzeinstellungen erwarten, als die Steuerung über das Magnetfeld, wohingegen ein höherer Zeitverbrauch zu erwarten ist.

Jede Veränderung der Energielücke verändert die Bedingung für die Arbeitsspannung, so daß die Steuerung der Arbeitsspannung an die aktuellen Werte der Energielücke gekoppelt sein soll.

Die Funktion Detektieren bedeutet, daß die elektrischen Wellen die optisch dünnen Schichten ohne Schwächung durchdringen, wobei sie mit Cooper-Paaren wechselwirken. Diese Wechselwirkungen führen zu erzwungenen Schwingungen und brechen dann die Cooper-Paare auf, wenn die Relation hf = DELTA erfüllt ist. Der entstehende Wechselstrom ist der Frequenz der elektrischen Wellen streng proportional.

Bei der Funktion "Senden", wenn die Arbeitsspannung größer als 2 DELTA ist, wird den Cooper-Paaren gleich bzw. mehr Energie zugeführt, als der Bindungsenergie der Cooper-Paare entspricht. Die Bindungsenergie der Cooper-Paare entspricht der Energielücke DELTA im Anregungsspektrum des Supraleiters. Es entstehen eine Mikrowellenstrahlung und Gitterschwingungen (Hyperschall). Die Frequenz der entstehenden elektrischen Wellen und die Frequenz der Gitterschwingungen sind der Größe der Energielücke streng proportional. Die Größe der Vorspannung entscheidet über: ein breitbandiges oder frequenzselektives Detektieren, über ein parametrisches Verstärken oder über das Senden, wobei die Größe der Vorspannung an die Größe der aktuellen Energielücke gekoppelt ist.

Wenn ein Tunnelstapel Detektieren, Senden, oder wenn einige Tunnelelemente parametrisch verstärken sollen, muß die Arbeitsspannung präzise Werte aufweisen. Wenn bestimmte Wellenlängen gewählt werden, muß die Energielücke bestimmte präzise Werte aufweisen. Die Arbeitswellenlänge oder umgerechnet die Arbeitsfrequenz wird über die dazu äquivalente Energielücke im Anregungsspektrum des Supraleiters erzielt. Die Energielücke in den supraleitenden Tunnelschichten wird - wie oben dargelegt - über Magnetfelder oder Temperaturen der supraleitenden Steuerschicht gesteuert. Die Steuerparameter sind von anderen Parametern wie beispielsweise der Energielücke abhängig und müssen daran gekoppelt werden. Wegen der großen Zahl der Tunnelelemente in einem Tunnelstapel und wegen der äußerst flexiblen möglichen Kombinationen mit verschiedenen Einstell- und Anwendungsfunktionen mit Kontrollstrukturen mit oder ohne Rückkopplungsmechanismen, automatisch oder halbautomatisch, ist es sinnvoll, eine intelligente Programmsteuerung einzusetzen. Vorzugsweise werden Prozeßrechner verwendet, wobei eine besonders gute Leistung dann erzielt wird, wenn alle Schalt- und Rechenvorgänge auf supraleitenden Schaltungen beruhen. Die Verwendung von neuronalen Netzen verbessert die Leistung.

Für verschiedene Anwendungen ist es erforderlich, eine Anzahl an Tunnelstapeln TS zu einem Tunnelstapelfeld F zusammenzufügen. In Fig. 9 ist ein Tunnelstapelfeld F auf einem Substratquader dargestellt, bei dem auf einer Fläche von 2,5 x 2,5 cm beispielsweise 25 000 Zeilen mit jeweils 25 000 Tunnelstapeln TS angeordnet sind. In dem Substratquader sind hinter den Tunnelstapeln TS digitale Kontaktwählschaltungen KW 1 für jeden Tunnelstapel TS vorgesehen, die zum Steuern aller Tunnelzellen im Stapel einzeln oder in beliebigen Kombinationen dienen. Im Anschluß daran ist eine digitale Kontaktwählschaltung KW 2 für alle Tunnelstapel TS vorgesehen, die wiederum mit Daten- und Steuerleitungen DS zu elektronischen Steckverbindungen auf der Rückwand des Quaders verbunden sind, wie sie von Steckkarten konventioneller Anlagen bekannt sind.

Die Flächenform für die Anordnung des Tunnelfeldes kann beliebig sein. Bevorzugt ist eine kreisförmige oder quadratische Fläche. Im allgemeinen wird ein Tunnelstapelfeld aus gleichartigen Tunnelelementen bzw. Tunnelstapeln zusammengesetzt. Für spezielle Anwendungen ist es jedoch auch möglich, verschiedene Ausführungen von Tunnelelementen und/oder Tunnelstapeln in einem Feld zu kombinieren.

Wie der Einzeltunnelstapel, befindet sich auch das Tunnelstapelfeld auf einer Kontaktplatte, die auf der Rückseite Platz für die Steuerungs- und Auswertelogik bietet. Dies kann in Modulbauweise, wie bei konventionellen Elektronikkarten, erfolgen. Dies bietet den Vorteil. große Schaltgeschwindigkeiten, etwa in der Größenordnung Picosekunden und kurze Signallaufzeiten für 1 cm etwa 10⁻¹¹ Sekunden, zu erzielen, was der besondere Vorteil der Supraleitungselektronik ist.

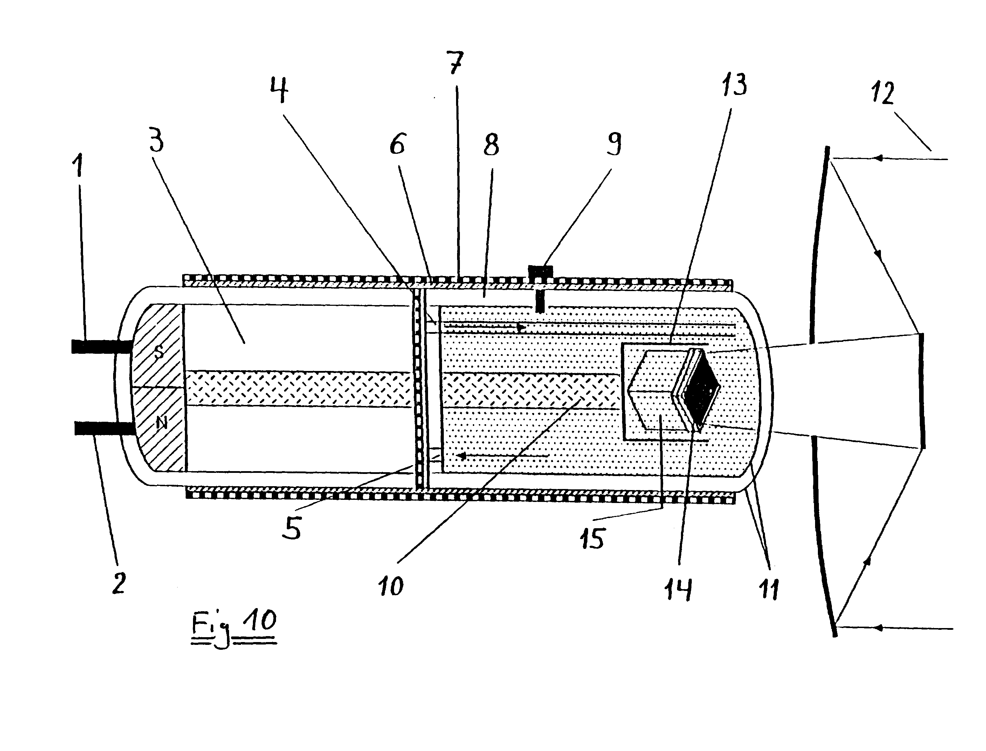

Eine bevorzugte Verwendung der Erfindung ist durch eine digitale supraleitungselektronische Kamera gegeben gegeben. In Fig. 10 ist das Schema einer digitalen supraleitungselektronischen Kamera im schwenkbaren Dewar mit Cassegrain-Spiegelsystem dargestellt.

Der allgemeine Aufbau eines Kryostaten ist bekannt und wird hier nicht beschrieben. Die in Fig. 10 angegebenen Bezugszeichen bedeuten:
1 supraleitende Steckverbindung
2 normalleitende Steckverbindung
3 miniaturisierte Verflüssigungsanlage nach dem Joule-Thomson-Prinzip
4 Zuleitung für flüssigen Stickstoff
5 Abflußleitung für flüssigen Stickstoff
6 Superisolierung
7 Stoßdämpfung aus Kunststoff
8 Vakuum
9 Sicherheitsventil
10 Montagehalter mit Steuer- und Signalleitung
11 Dom
12 Cassegrain-Parabolspiegel
13 Abschirmung auf Supraleitungsbasis
14 Tunnelstapelfeld
15 Auswerteelektronik auf Supraleitungsbasis.
Die eigentliche digitale supraleitungselektronische Kamera besteht aus folgenden Baugruppen: einem oder mehreren Substratquadern mit je einem Tunnelstapelfeld, einer elektronischen Steuerung zur Bedienung der Tunnelstapel, einem supraleitenden Schirm gegen Störfelder und Steuer- und Signalleitungen.

Jeder einzelne Tunnelstapel kann als ein multispektrales Sende- und Empfangssystem aufgefaßt werden. Wenn man einer angestrebten Auflösung entsprechend genügend viele Tunnelstapel zeilenweise in einem Feld oder auf einer Fläche anordnet, können die entstehenden einzelnen Signalpunkte zu einem Bild zusammengesetzt werden, wodurch durch das Tunnelstapelfeld das Raum gebiet im Blickwinkel der Kamera abgebildet werden kann. Da jeder Tunnelstapel ab einer kurzweiligen Grenze in Richtung längerer Wellenlängen unbegrenzt frequenzselektiv sehen kann, bekommt die Kamera wegen der Frequenzabhängigkeit der Absorption durchdringende Eigenschaften. Die Kamera ermöglicht folgende Funktionen: den Erhalt von Infrarot- und Mikrowellenbildern auf der Basis jeder gewünschten Wellenlänge, Präzisionsvermessungen von Objekten im Raum durch Laufzeitmessungen und ein erstelltes Koordinatensystem und die Erfassung von Spektren chemischer Verbindungen, die den Vergleich mit Daten in Spektralbibliotheken ermöglichen. Somit kann die Kamera ganz besonders zum Auffinden, Vermessen und Identifizieren von Objekten verwendet werden.

In Fig. 10 ist die Kamera mit einem Cassegrain-Parabolspiegel versehen, in dessen Brennpunkt sich das Tunnelstapelfeld befindet. Die Kamera kann selbstverständlich auch ohne Spiegel eingesetzt werden. Eine andere Anwendungsmöglichkeit besteht darin, sie in einem schwenkbaren Dewar mit flüssigem Helium statt mit flüssigem Stickstoff anzuwenden, wobei ein zusätzlicher Strahlungsschirm mit flüssigem Stickstoff (nicht dargestellt) vorgesehen ist. Der Kamera ist ein weiterer Spektralbereich zugänglich, der im kurzwelligen Bereich bei einigen Mikrometern beginnt und dann im langwelligen Bereich praktisch bis unendlich gehen kann. Hierdurch ist es möglich, laufend Bilder auf der Basis einer beliebigen Frequenz von Objekten anzufertigen. Das frequenzselektive Fortschreiten zu längeren Wellenlängen führt zur Fähigkeit der Kamera, auch in das Innere der Objekte zu sehen. Es ist möglich, Präzisionsmessungen von IR- und Mikrowellenspektren mit hoher Auflösung zu erzielen, die im Vergleich mit gespeicherten Spektren einer Datei eine chemische Analyse ermöglichen. Mit Hilfe von Dopplermessungen können radiale Geschwindigkeiten gemessen werden. Weiter kann mit einer beliebigen Frequenz oder einer beliebig gewählten Gruppe von Frequenzen gesendet und die Laufzeit bis zum Eintreffen des Echos gemessen werden, was räumliche Erfassungen ermöglicht. Durch Messung der Planck'schen Strahlungskurve und durch Bestimmung ihres Maximus kann die Temperatur an einem Zielort berechnet werden. Die Präzisionsmessung der Infrarot- und Mikrowellenspektren ist deshalb besonders wichtig, weil die gesamte Information über den molekularen Aufbau in den Infrarot- bzw. Mikrowellenspektren enthalten ist. Daher kann durch eine Gesamtanalyse jedem beobachteten Spektrum der dazugehörige Molekülaufbau zugeordnet werden. Da verschiedene Verbindungen nie gleiche Infrarotspektren aufweisen, sind diese wie Fingerabdrücke und damit ein sicheres Hilfsmittel der qualitativen Analyse zur Identifizierung unbekannter chemischer Verbindungen, die durch Vergleich des Spektrums der unbekannten Verbindung mit bekannten Spektren erfolgt. Es kann durch gezielte Impulsstrahlung z.B. durch geeignete Mikrowellen von speziellen supraleitenden Tunnelstapeln eine Anzahl von chemischen Verbindungen angeregt werden, die dann ihr eigenes Rotationsspektrum imitieren, über das die Verbindungen identifizierbar sind. Die zeitlich abklingenden Emissionssignale werden in Abständen von wenigen Nano-Sekunden abgetastet und per Rechner verarbeitet.

Für nicht mit Rotationsspektren erfaßbare nichtpolare Verbindungen, wie z.B. die Gase Wasserstoff, Sauerstoff, Stickstoff, können Raman-Spektren ausgenutzt werden, die durch unelastische Streuung von Photonen an den Molekülen entstehen. Aus den Raman-Spektren lassen sich Aussagen über die Frequenzen der Eigenschwingungen die Trägheitsmomente und die Form der Moleküle ermitteln. Beim frequenzselektiven Sehen mit der Kamera dringt diese mit dem Anwachsen der Arbeitswellenlänge immer weiter in die Objekte ein und setzt diese Informationen z.B. für ein bildgebendes Verfahren um. Wenn alle geeigneten Wellenlängen voneinander getrennt zur Informationsgewinnung herangezogen werden, sind auch Informationen aus dem Inneren der Objekte zu gewinnen. Eine Anwendung liegt beispielsweise auch in der Chirurgie darin, daß in Wunden zwischen Verschmutzungen und lebendiger Substanz unterschieden werden kann.

In der Anwendung der Kamera zum Lesen und Verstehen von Molekülspektren sind sehr geringe Strahlungsleistungen gegeben. Wegen der konkurrenzlosen Empfindlichkeit supraleitender Tunnelschaltungen sind sehr schwache Signale erfaßbar, wobei die sich summierenden Schaltzeiten durch die hohe Schaltgeschwindigkeit dennoch hohe Auflösungen ermöglichen, so daß Molekülspektren mit feinsten Strukturen erkannt werden können, wobei auch Mischspektren besser identifizierbar sind.

Die Kamera durchfährt zum Lesen der Spektren das ganze Spektralgebiet mit einer wählbaren Registriergeschwindigkeit. Die Registriergeschwindigkeit wird durch Zeiten vorgegeben, die die physikalischen Prozesse durchlaufen. Die Koordinatenmaßstäbe werden durch Feinstrukturen vorgegeben, die gemessen werden können und müssen. Der Spektrenmaßstab für die Abszisse könnte beispielsweise aus einer Wellenlängenunterteilung bestehen, die die feinsten Strukturen erfaßt. Für die Ordinate müßte die maximale Intensität erfaßt werden und trotzdem könnte eine Feinauflösung der Intensität erreicht werden.

Da Bilder aus vielen einzelnen Bildpunkten zusammengesetzt werden, werden die Tunnelstapel zeilenweise zu einem Feld geordnet, so daß aus dem durch einen Tunnelstapel, der eine Information als einen Bildpunkt gibt, nunmehr die einzelnen Bildpunkte zu einem aus vielen Bildpunkten bestehenden Bild zusammengesetzt werden. Durch die Möglichkeiten der individuellen Schaltung jedes Tunnelstapels kann die Kamera analytische Vorgänge bis hin zum Vermessen und Identifizieren von Objekten ausführen.

Die Sendeenergie einer einzelnen Tunnelzelle ist sehr gering und liegt in der Größenordnung Nano- bis Mikrowatt. Über das Summationsprinzip im Tunnelstapel und über eine spezielle Auslegung der Tunnelelemente kann die Sendeenergie um viele Größenordnungen gesteigert werden.

Die Packungsdichte der Tunnelstapel pro Fläche muß so ausgelegt werden, daß die Zahl der Tunnelstapel und damit die Zahl der Bildpunkte zu einer maximalen Auflösung führen. Durch die Flexibilität der Schaltung ist es möglich, einen Bildpunkt nicht nur durch ein einziges Tunnelelement zu erzielen, sondern es können auch mehrere Tunnelelemente für die Erstellung eines Bildpunktes zusammengeschlossen werden. Je nach Wunsch kann diese Zusammenschaltung eine variable Sensorfläche für einen neuen Bildpunkt ergeben.

Wenn die verwendete Wellenlänge groß im Vergleich zur Sensorfläche wird, können für das Arbeiten im langwelligen Spektralbereich mehrere räumlich getrennte Sensorflächen zusammengeschaltet werden, um die Auflösung mit den Methoden der Interferometrie zu verbessern. Die Distanzen zwischen den zusammengeschalteten Tunnelstapelflächen müssen viel größer als die verwendeten Wellenlängen sein. Das bedeutet, daß wenn man mit einem Suchgerät Verschüttete unter 20 m Trümmem erkennen will, Bausätze mit einigen Metern Flächenausdehnung notwendig sind.

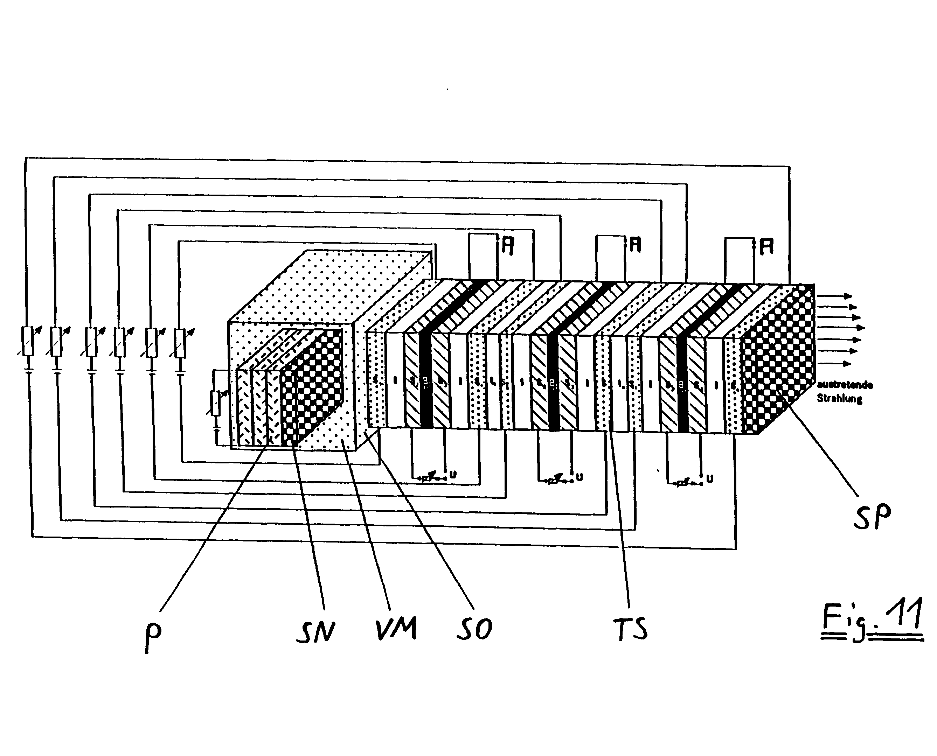

Eine weitere Anwendung der Erfindung besteht in supraleitungselektronischen kohärenten Strahlern. In Fig. 11 ist ein supraleitungselektronischer kohärenter Strahler mit normalen Spiegeln dargestellt. Der Tunnelstapel TS umfaßt mehrere Tunnelelemente der in Fig. 1 abgebildeten Art. Er kann alternativ auch aus Tunnelelementen nach Fig. 2 oder nach Fig. 3 (letztere mit oder ohne Promimity-Schichten P1,P2) aufgebaut sein. Mit P ist ein Piezo-Stapel, der mit Serienschaltung im Substrat angeordnet ist, mit SN ist der auf dem Piezo-Stapel P befindliche bewegliche Spiegel, mit VM das Vakuum, mit SO die Substratoberfläche und mit SP ein von außen durchlässiger und von innen halbdurchlässiger, das heißt reflektierender Spiegel bezeichnet.

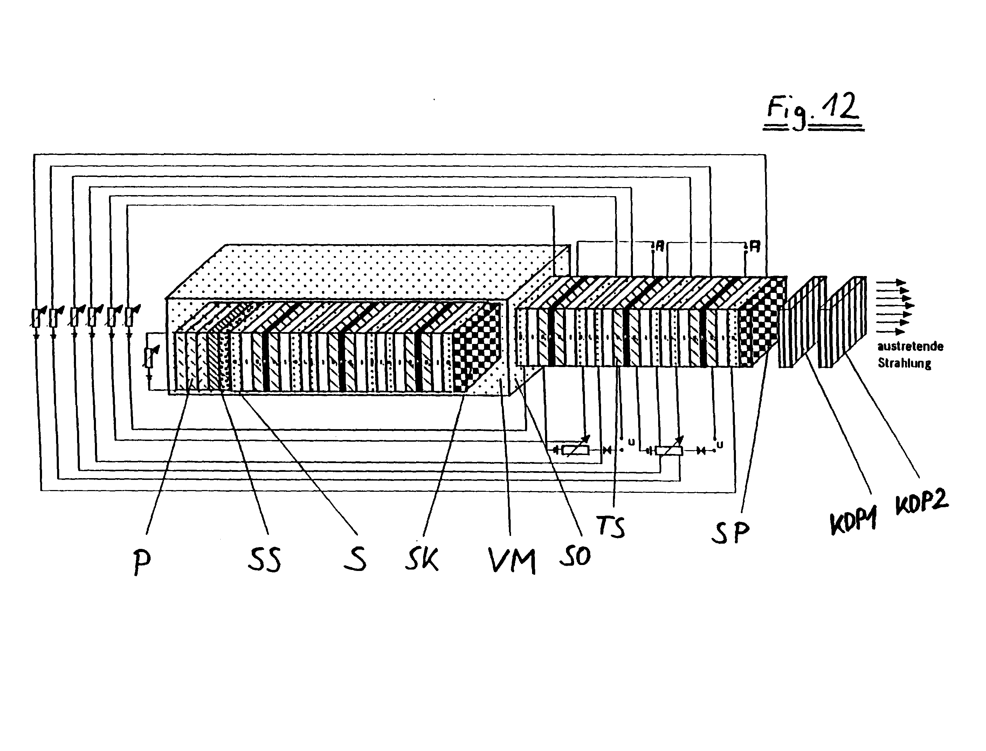

In Fig. 12 ist ein supraleitungselektronischer kohärenter Strahler mit phasenkonjugierten Spiegeln und mit Frequenzvervielfachung dargestellt. Die beim Strahler gemäß Fig. 11 enthaltenen Bauteile weisen die gleichen Bezugszeichen auf. Zusätzlich ist ein supraleitender Schirm SS, Ein Substrat S und ein phasenkonjugierter Spiegel SK vorgesehen, wobei zwischen dem Piezo-Stapel P, ein supraleitender Schirm SS, ein Substrat S und zwei Tunnelstapel TS aus einzelnen Tunnelelementen nach Fig. 1 angeordnet sind. Die Tunnelstapel TS können aber auch aus Tunnelelementen nach Fig. 2 oder nach Fig. 3 (letztere mit oder ohne Promimity-Schichten P1,P2) aufgebaut sein. Vor dem von aussen durchlässigen und von innen halbdurchlässigen Spiegel SP sind zur Frequenzvervielfachung noch zwei Kristalle aus Kaliumdihydrogenphosphat KDP 1 und KDP 2 angeordnet. Selbstverständlich kann der Strahler gemäß Fig. 12, wenn eine Frequenzvervielfachung nicht erwünscht ist, als supraleitungselektronischer kohärenter Strahler mit phasenkonjugierten Spiegeln ohne die Kristalle aus Kaliumdihydrogenphosphat KDP 1 und KDP 2 ausgeführt sein.

Bezüglich der Schaltung wird auf die Schemata gemäß Fig. 11 und 12 verwiesen. Alle Strahler weisen gemeinsam einen spezifischen Substratquader, Mikropiezopositioniersysteme. spezifische Tunnelstapel, ein Resonatorsystem, einen Montagehalter mit Steuer- und Signalleitungen, sowie spezielle elektronische Steuerungen zur Bedienung der Mikropiezopositioniersysteme und Tunnelstapel auf.

Die Tunnelelemente im Stapel sind für hohe Tunnelströme und hohe Intensitäten optimiert und ausgelegt. Die aus der Anzahl der Tunnelelemente im Tunnelstapel resultierende Intensität wird mindestens so groß ausgelegt, daß die nicht linearen phasenkonjugierten Spiegel arbeiten können und daß auf die Chemie der Zielverbindungen über die Zuführung von genau dosierter Strahlungsenergie mit der erforderlichen Frequenz - oder einer Gruppe von Frequenzen - Einfluß genommen werden kann. Für Verwendungen des Strahlers zu Modulationsaufgaben im Stoffwechsel sind monochromatische und kohärente Strahlungen erforderlich, wobei als monochromatische Strahlung ein Mikrowellenstrahl definiert ist, wenn seine Teilwellen alle die gleiche Wellenlänge bzw. die gleiche Frequenz haben. Monochromatisch muß die Strahlung sein, um mit einer anwendungsorientiert gewählten Wellenlänge oder Frequenz auf einen chemischen Prozess einwirken zu können. Kohärent ist ein Mikrowellenstrahl, wenn seine Teilwellen alle konstante Differenzen in ihren Phasen konstanten haben, wobei zwischen den Teilwellen feste Phasenbeziehungen bestehen müssen, da sonst die Wellen nicht miteinander interferieren können. Die Strahlung muß kohärent sein, wenn holographische Anwendungen gewünscht werden.

Ein auf maximale Sendeintensität optimierter Tunnelstapel wird in einen Mikrowellenresonator eingebaut, wobei das Resonatorprinzip der Lasertechnik übernommen wird. Der Resonator speichert die Energie, die für die Resonanz bzw. Eigenfrequenzen ein Maximum annehmen.

Wenn die Frequenz der Arbeitswelle gleich der Resonanzfrequenz ist, entsteht zwischen den Spiegeln eine stehende Welle und die Strahlungsdichte im Resonator nimmt ein Maximum an. Daher muß der Resonator durch eine variable Resonatorlänge auf alle Frequenzen einstellbar sein. Im Substratquader wird auf dem Piezo-Stapel das jeweilige Spiegelsystem angeordnet, im Falle eines phasenkonjugierten Spiegels in Form eines nicht linearen Kristalls. Bevorzugt wird ein Vierwellenmischprinzip verwendet. Mit der Phasenkonjugation ist es u.a. möglich, Phasenstörungen und Aberrationen optischer Systeme zu korrigieren. Am anderen Ende des Stapels, auf der der Strahlung zugewandten Seite, werden Spiegel aus supraleitendem Material bevorzugt, um die besonderen Vorteile der Supraleitung für Spiegelungen nutzen zu können.

Die physikalischen Eigenschaften der Tunnelstapel ermöglichen die Erzeugung einer Strahlung mit beliebigen Frequenzen. Die feste Phasenbeziehung der Supraleitung sorgt für die kohärente Eigenschaft und das Resonatorsystem sorgt durch Interferenz für die monochromatische Eigenschaft der Strahlung. Bei der in Fig. 12 dargestellten Version des Strahlers werden mit der Methode der Frequenzvervielfachung nichtlinearer Kristalle die Strahlungseigenschaften des Strahlers bis auf den ultravioletten Bereich ausgedehnt. Mit Hilfe der beiden KDP-Kristalle wird in einem zweistufigen Prozess die dreifache Frequenz der Ausgangsfrequenz des Tunnelstapels erzeugt. Dies kann bis zur Wellenlänge von etwa 0,250 Mikrometer durchgeführt werden. Für höhere Frequenzen ist der Kristall nicht mehr transparent. Die erzeugte Strahlung ist monochromatisch und kohärent.

Phasenkonjugierte Spiegel können nach zwei Verfahren hergestellt werden. Einmal durch Vierwellenmischung und zum anderen durch induzierte Streuung. Phasenkonjugierte Spiegel sind nichtlineare optische Spiegel, die die Strahlung nur ab einer bestimmten Leistungsdichte reflektieren. Beim phasenkonjugierten Spiegel konvergiert die reflektierte Welle und breitet sich entgegengesetzt oder "zeitumgekehrt" zur einfallenden Welle aus. Dies bedeutet, daß die Welle nicht dem Reflektionsgesetz ebener Spiegel gehorcht, sondern in sich selbst zurückläuft. Phasenstörungen in optischen Systemen können mit Hilfe von Phasenkonjugatoren kompensiert werden, in dem das optische System zweifach in entgegengesetzten Richtungen durchlaufen wird. Bei einem phasenkonjugierenden Spiegel sind die Wellenfronten der einfallenden und der reflektierten Welle gleich, aber die Ausbreitungsrichtung ist an jeder Stelle der Wellenfront umgekehrt. Die in einem Tunnelstapel entstehende Mikrowellenstrahlung wird von einem Phasenkonjugator in den Stapel zurückreflektiert. Die stattfindende Interferenz des Resonatorsystems führt zu der angestrebten monochromatischen Welle, die dann aus dem Strahlengang ausgekoppelt wird. Die Phasenkonjugation führt zu einer Verdopplung der effektiven Verstärkerlänge bei gleichzeitiger Elimination von Phasen störungen im Tunnelstapel. Zusätzlich ergibt sich eine verringerte Empfindlichkeit gegenüber möglichen Dejustierungen der Spiegel. Phasenkonjugatoren ermöglichen linsen lose Abbildungen.

Die Länge eines Resonatorsystems für Tunnelstapel muß wegen der sich ändernden Arbeitswellenlängen des Tunnelstapelsystems flexibel sein und darf nicht behindert werden. Es ist daher eine automatische Längenanpassung des Resonatorsystems an die jeweiligen Erfordernisse notwendig, wozu sich die Piezo-Technik anbietet. In Fig. 11 ist ein Tunnelstapel, der sich auf einem ausgewählten Substrat befindet, im Resonator dargestellt. In diesem Substratquader sind alle Steckverbindungen vorgefertigt. Der Substratquader kann Ausdehnungen mit mehreren cm Seitenlänge und einer Dicke von mehreren mm bis mehreren cm aufweisen. Für die Resonatorversion des Tunnelstapelsystems bietet es sich an, den beweglichen Spiegel der am Ende eines Piezo-Systems - bevorzugt eines Piezo-Stapelsystems- angeordnet ist, mit dem ganzen Piezo-Positioniersystem in den Substratquader einzubauen. Das Piezo-Mikropositioniersystem muß eine eigene Spannungsversorgung haben, und es muß für Präzisionspositionierungen in der Größenordnungen von Bruchteilen einer Atom lage Genauigkeit aufweisen. Die Länge des Piezo-Stapels ändert sich mit der Spannung bis zu einem Maximalwert der material-spezifischen Ausdehnung. Die Längenänderungen erfolgen in Mikrosekunden und schneller. Für ein mm ist eine Spannung von etwa 200 V erforderlich. Wegen der hohen Spannung, die bei mehreren tausend Volt liegen kann, wenn die Piezo sich um einige mm strecken oder sich zusammenziehen sollen, wird die supraleitende Abschirmung erforderlich. Der Piezo-Stapel wird dazu mit supraleitendem Material eingekapselt.

Wenn eine Phasenkonjugation auf der Basis einer Vierwellenmischung vorgesehen ist, erfordert dies eine zweite Mikrowellenquelle. Sie wird durch einen zweiten Tunnelstapel mit gleicher Spezifikation auf der dem Signal entgegengesetzten Seite realisiert. Die Reihenfolge ist dann: Piezo-Stapel-Tunnelstapel zur Erzeugung einer Vergleichswelle - nicht linearer KristallTunnelstapel zur Erzeugung der Signalwelle und zum Auslesen der phasenkonjugierten Welle - einseitig wirkenden halbdurchlässiger Spiegel. Ein spezifischer Tunnelstapel, der speziell für den Anwendungsfall optimiert sein kann, befindet sich auf der Oberfläche des Substratquaders der eigentlichen Substratfläche. Der Tunnelstapel hat die Ausdehnung einer Folie. Auf seiner Oberfläche und in Strahlungsrichtung befindet sich der zweite Resonatorspiegel. Für den zweiten Spiegel können die Vorteile supraleitender Spiegel genutzt werden. Er muß einseitig halbdurchlässig spiegelnd wirken und zwar nur nach innen zurück in den Tunnelstapel.

Für ein Resonatorsystem für die Feldanordnung vieler Tunnelstapel auf einer kleinen Fläche bieten sich drei Lösungswege an.
1. Ein beweglicher Spiegel für alle Tunnelstapel im Substrat und ein fest angeordneter oder beweglicher zweiter Spiegel für alle Tunnelstapel am gegenüberliegenden Ende der Tunnelstapel (Separatanbringung), die Tunnelstapel sind frei im Resonatorsystem).
2. Der zweite Spiegel wird individuell am Ende jedes Tunnelstapels angeordnet und
3. für jeden Tunnelstapel wird ein eigenes Mikropositioniersystem vorgesehen, vorzugsweise als letzte Schicht auf dem Tunnelstapel.

Bei der Lösung gemäß 1. kann man mit einem beweglichen Spiegel alle Tunnelstapel bedienen, wobei der unbewegliche bzw. bewegliche zweite Spiegel ebenfalls ein größerer Spiegel sein könnte, der wiederum für alle Tunnelstapel zuständig und gegebenenfalls gesondert einzubauen wäre. Auch wenn dieser zweite Spiegel für jeden Stapel individuell am Ende des Stapels gefertigt würde, müssen alle Tunnelstapel bei dieser Version jeweils mit der gleichen Wellenlänge arbeiten.

Gemäß der Lösung 3, die die größtmögliche physikalische Flexibilität eines Tunnelstapelresonatorfeldes zu erreichen ermöglicht, muß jeder Tunnelstapel sein eigenes Mikropositioniersystem erhalten, das dann dem gesamten System erlaubt, beliebige Kombination kohärenter monochromatischer Strahlen zusammenzustellen. Der einzelne Tunnelstapel darf nur mit jeweils einer Wellenlänge arbeiten. Die mit Hilfe vieler Tunnelstapel gewählte Kombination mit verschiedenen Wellenlängen kann dann von jedem Tunnelstapel individuell gleichzeitig gesendet werden.

Ein Piezo-Element oder ein Piezo-Stapel weist Ausdehnungen in der Größenordnung Millimeter in der Länge und Mikrometer im Durchmesser auf. Das Piezo-Stapelsystem ist damit viel länger als ein Tunnelstapel, dessen Durchmesser und dessen Länge bei Mikrometern liegen. Mit zunehmender Länge des Piezo-Stapels wächst auch die Längenausdehnung. Der Durchmesser des Piezostapels und des Spiegels muß in etwa mit dem Durchmesser des jeweiligen Tunnelstapels übereinstimmen.

Das ganze Piezo-Spiegelsystem wird in einem Substratquader eingebaut, wobei für die Bewegung der Spiegel ausreichend Leerraum zwischen Stapel und Substratfläche vorgesehen werden muß. Die Substratfläche muß so bezüglich ihres Materials ausgewählt und in ihrer Geometrie ausgelegt werden, daß sie durchlässig für eine Strahlung, bevorzugt im Infrarot- und Millimeterspektrum, ist. Das stabilisierende Isoliermaterial im Raum zwischen den Piezo-Stapeln darf die Arbeit der Stapel nicht behindern. Die Piezos müssen sich ungehindert strecken und zusammenziehen können. Dies könnte beispielsweise mit Substratmaterial geschehen, das dann ebenfalls Ebene für Ebene mitentstehen müßte.

Auf der Aussenseite der Substratfläche befindet sich dann der Tunnelstapel oder das Tunnelstapelfeld mit jeweils dem zweiten Spiegel soll als Auskoppelungsspiegel für die von aussen kommende Strahlung durchlässig sein, was nach dem Prinzip einseitig durchlässiger Fenster erfolgt.

Der neue kohärente Strahler hat Strahlungseigenschaften wie Lasersysteme, dehnt sie aber über das ganze Spektralgebiet aus. Wegen seiner gegenüber dem Lasersystem freien Wahl der Wellenlänge bzw. der Frequenz, lassen sich die Strahler beispielsweise für medizinische, biologische und chemische Anwendungen einsetzen. Zum Einsatzgebiet gehört auch die Holographie und die holographische Interferometrie, wobei unter holographischer Interferometrie Bilder von Objekten verstanden werden, die von solchen Interferenzstreifen durchzogen sind, die Linien konstanten Abstandes zwischen zwei Zuständen der Objekte entsprechen. Die holographische Interferometrie dient zur Schwingungsanalyse, zur Materialüberprüfung und zur Untersuchung der Gestaltsänderung von Werkstücken, die z.B. Temperatur und/oder Druckänderung unterworfen werden. Ein Einzelstrahler kann Bauelement anderer Geräte sein. Wenn chemische Veränderungen durch präzise Energiezufuhr und präzise Resonanzbedingungen durchgeführt werden, wäre es wünschenswert, diesen komplexen chemischen Prozeß mit einer beliebigen Summe individuell verschiedener Strahlungsenergien und Resonanzbedingungen zeitgleich zu modulieren, was durch ein Tunnelstapelresonatorfeld möglich ist, das ebenfalls Bauelement anderer Geräte sein kann.

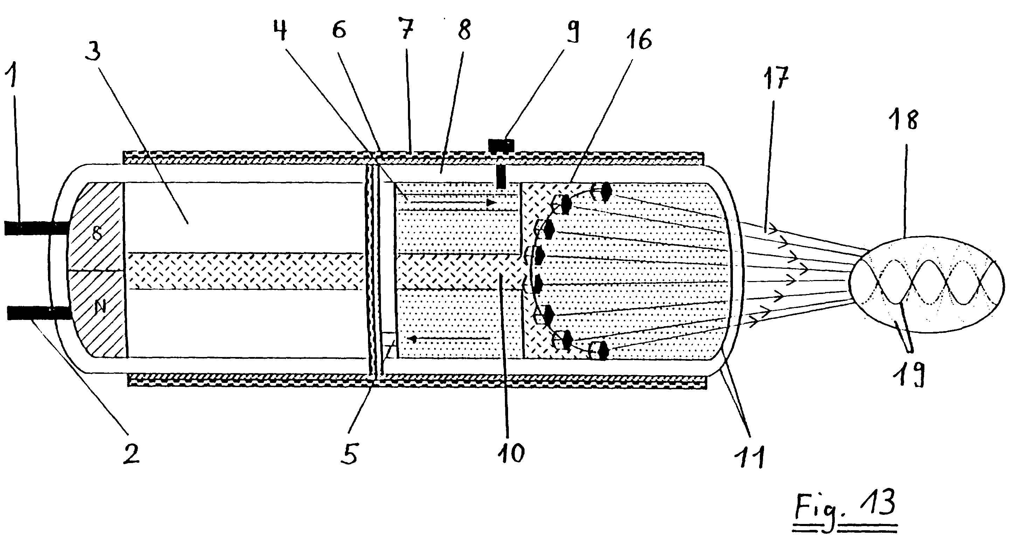

In Fig. 13 ist das Schema einer Vorrichtung zur Mikropositionierung innerhalb lebender Zellen, im folgenden auch als supraleitungselektronische Strahlenpinzette bezeichnet, dargelegt. Die Bezugszeichen 1 bis 11 haben die bei Fig. 10 erläuterte Bedeutung. Ferner weist die Strahlenpinzette einzelschwenkbare kohärente supraleitungselektronische Strahler 16 auf, deren Strahlen 17 in einer Zelle 18 stehende Wellen 19 induzieren. Die stehenden Wellen 17 positionieren Zellorganellen im Inneren einer lebenden Zelle, wobei deren Minima und Maxima ortsfest sind.

Die supraleitungselektronische Strahlenpinzette besteht somit im wesentlichen aus einem supraleitungselektronischen Strahler für monochromatische und kohärente Wellen. Die durch den Tunnelstapel mögliche hohe Flexibilität gewährleistet es, daß sie auf allen Wellenlängen präzise arbeiten kann. Damit können auch analytische und diagnostische Hilfen des supraleitenden Sende- und Empfangssystems Mikroarbeiten in einer geschlossenen Zelle durch ständige Rückkopplung mit aktuellen Meßergebnissen unterstützen. Individuell justierbar stehende Wellen in einer Gruppe zusammengefaßt als Strahlenpinzette dienen, wie schon erwähnt, beispielsweise zum Positionieren von Zellorganellen. Eine supraleitungselektronische Strahlenpinzette besteht aus folgenden Baugruppen: mehrere Substratquader in sphärischer Anordnung mit einem Fels supraleitungselektronischer kohärenter Strahler, Präzisionsjustiervorrichtungen für die Strahler, elektronische Steuerung zur Bedienung der Tunnelstapel, elektronische Steuerung zur Bedienung der Piezo-Stapel, supraleitende Schirme gegen Störfelder und Montagehaltern mit Versorgungsleitungen (Steuer- und Signalleitungen; siehe auch die Schaltschemata in Fig. 11 und 12).

Mehrere Bausätze, die unter verschiedenen Winkeln positioniert sind bilden eine arbeitsfähige Strahlenpinzette, mit der dann von mehreren Seiten und aus unterschiedlichen Winkeln Mikropositionierungen vorgenommen werden können. Die Steuerung der Strahlenpinzette muß stehende Wellen in der zu bearbeitenden Zelle herbeiführen, aufrechterhalten und im Sinne der Positionierarbeiten steuern.

Die Erfindung kann auch für Quanteninterferenzgeräte (SQUID) eingesetzt werden. SQUID ist die Abkürzung für super conducting quantum interferenz devices. Die Funktion der SQUIDS beruht auf dem Josephson-Effekt. Josephson-Elemente unterbrechen einen supraleitenden Ring, in dem ein Suprastrom induziert wird.

Eine supraleitende Schleife, die durch einen Tunnelkontakt unterbrochen ist, heißt RF-SQUID. Eine supraleitende Schleife, die symmetrisch durch zwei Tunnelkontakte unterbrochen ist, heißt DC-SQUID. Eine SQIUD-Anlage bietet eine Empfindlichkeit zur Messung magnetischer Felder, die sechzehn Grössenordnungen der magnetischen Feldgröße umfaßt. Die Nachweisgrenze für die Feldgrenze liegt bei 10⁻¹⁵ Tesla, was die Messung kleinster Feldunterschiede und kleinster Feldstärken ermöglicht. Anwendungen solcher SQUID-Systeme sind deshalb extrem schwache Magnetfelder, wie sie in der Medizin, in der Altlastauffindung und in der Lagerstättensuche auftreten.

Wenn auf einen supraleitenden Ring ein elektromagnetisches Feld einwirkt, wird in dem Ring ein Suprastrom erzeugt. Das Feld dringt mit einer bestimmten Tiefe in den Supraleiter ein, und ab einer bestimmten Feldstärke wird die Supraleitung zerstört. Wird der Ring durch einen supraleitenden Tunnelkontakt unterbrochen, wird wegen des viel kleineren kritischen Stroms des Tunnelkontaktes, der kritische Strom erreicht und die Kontaktstelle wird normalleitend, das heißt der Stromfluß im Ring wird unterbrochen. Der durch ein Tunnelelement fließende Suprastrom induziert in den supraleitenden Steuerschichten, die sich zwischen den supraleitenden Tunnelschichten befinden, eine Spannung, so daß die Steuerschichten die Aufgabe der Induktionsspule zum Auskoppeln der Signalspannung übernehmen. Wenn sich n Tunnelelemente in einem Stapel befinden, dann wird in n Tunnelelementen bei jedem Stromfluß der Tunnelstrom jeweils eine Spannung in den integrierten Steuerschichten induzieren. Durch Reihenschaltung der Steuerschichten im Stapel wird die Induktionsspannung entsprechend der Anzahl der Tunnelelemente summiert. Vorteilhafterweise wird die Anzahl der Tunnelelemente in einem Tunnelstapel so hoch gewählt, daß die konventionellen Vorverstärker überflüssig werden. Weiterhin ist es möglich, eine oder mehrere Tunnelelemente in einem Tunnelstapel zur parametrischen Verstärkung des Signals noch im Ring zu schalten.

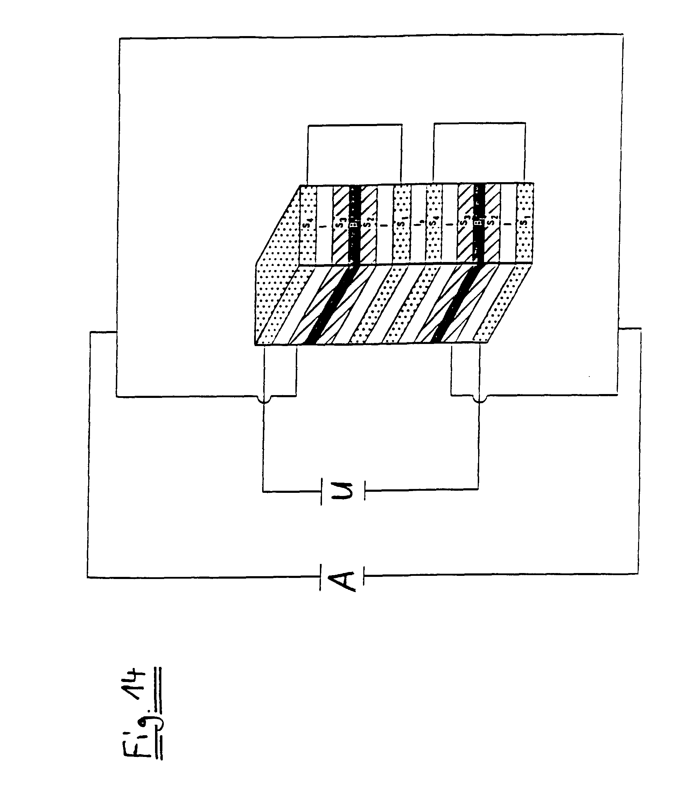

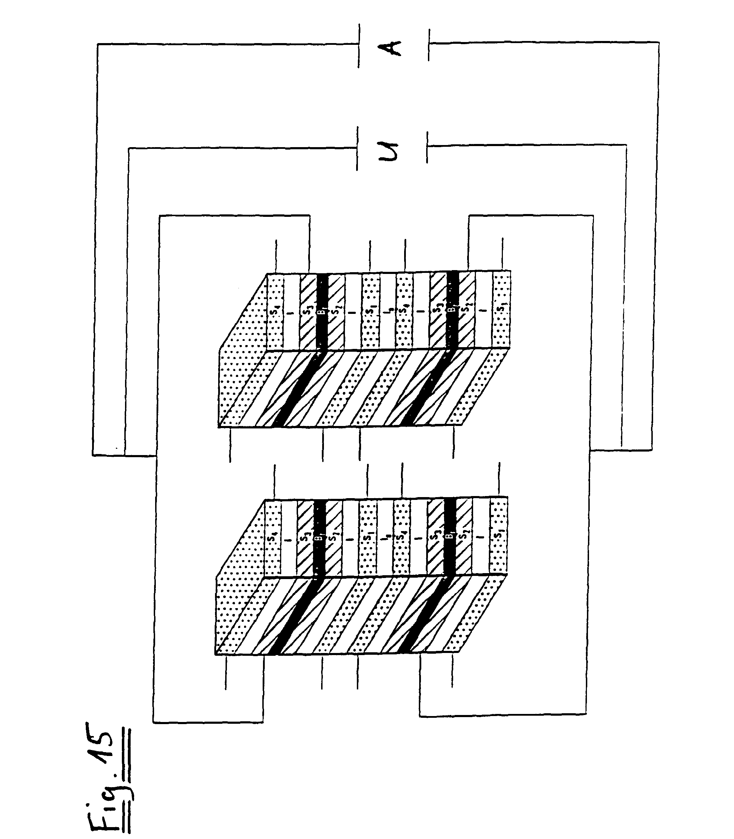

Fig. 14 zeigt ein Schema eines RF-SQUIDS auf Tunnelstapelbasis (mit zwei Tunnelelementen gemäß Fig. 1, alternativ können auch Tunnelelemente nach Fig. 2 oder nach Fig. 3, letztere mit oder ohne Promimity-Schichten P1,P2, verwendet werden) , wobei die Signalspannung U induktiv über die supraleitenden seriell geschalteten Steuerschichten abgegriffen wird. In Fig. 15 ist ein Schema eines DC-SQUIDS auf Tunnelstapelbasis (mit jeweils zwei Tunnelelementen gemäß Fig. 1, alternativ können auch Tunnelelemente nach Fig. 2 oder nach Fig. 3, letztere mit oder ohne Promimity-Schichten P1,P2, verwendet werden) mit jeweils zwei Tunnelelementen gemäß Fig. 1) dargestellt, bei dem die Signalspannung U seriell über die Tunnelspannung abgegriffen wird.

Das in Fig. 14 dargestellte RF-SQUID-System besteht aus einem supraleitenden Ring, der durch einen Tunnelstapel unterbrochen ist. Die Signalspannung wird über die im Tunnelstapel vorhandenen supraleitenden Steuerschichten in einer Reihenschaltung aufsummiert und dann der Signalverarbeitung zugeführt. Die Vorteile bei Verwendung des Tunnelstapels im RF-SQUID liegen in der Summierung der Signalspannung. Eine um drei bis vier Größenordnungen höhere Signalspannung benötigt keine aufwendige Verstärkerelektronik. Das wesentlich kompaktere RF-SQUID-System kann damit für vielfältige Aufgaben gezielt angepaßt werden.

Das in Fig. 15 dargestellte DC-SQUID-System mit zwei symmetrisch angeordneten Josephson-Tunnelelementen summiert bei einer Reihenschaltung aller Tunnelelemente im Stapel die Tunnelspannung. Durch Anlegen definierter Spannungen an die Steuerschichten beider Stapel können die beiden Tunnelsysteme justiert werden. Die Tunnelstapel allein liefern um drei bis vier Größenordnungen größere Signalspannungen, wodurch eine aufwendige Verstärkerelektronik entfallen kann. Ein Tunnelstapel im RF-SQUID, bzw. zwei Tunnelstapel im DC-SQUID werden auf einem Substratquader mit Halterung vorgesehen. Der freie Ringteil befindet sich in Signalrichtung. Das ganze SQUID-System ist in einem Kryostaten angeordnet.

Die Empfindlichkeit derartiger supraleitungselektronischer Tunnelschaltungen ist so groß, daß Entfemungen zu den Zielen in einem Raum gebiet für auszuführende Messungen um Größenordnungen höher ausfallen können. Es sei beispielsweise ein Geländeabschnitt mit einer bestimmten Länge und Breite vorgegeben. In unterschiedlicher Bodentiefe werden zu suchende Körper (Altlasten) vermutet. Zum Detektieren teilt man diesen Abschnitt in eine bestimmte Anzahl Streifenabschnitte ein, die man mit einem Bodenfahrzeug oder mit einem Fluggerät abfährt, bzw. abfliegt. Die Streifenbreite ist abhängig vom Gesichtsfeld und der Auflösung der Sensoranlage, die vorzugsweise mindestens der Fahrzeugbreite entspricht. Für den Aufbau eines bildgebenden und identifizierungsfähigen Verfahrens muß der Feldsensor das zu untersuchende Raum gebiet abtasten. Das jeweils darzustellende Gesichtsfeld der Bodenoberfläche könnte in ein Netz mit einer bestimmten Anzahl Zeilen eingeteilt werden. Auf einer Zeile würde dann eine definiert Anzahl von Meßpunkten vorgesehen. Die Dichte des Netzes, das heißt die Dichte der Zeilenmeßpunkte und die Breitenabstände zwischen den Zeilen, würde als Funktion der Meßempfindlichkeit, der Größe der abzusuchenden Fläche und der auftretenden Entfernungen optimiert. Wenn ein einziger Sensor verwendet wird, muß er jedem Meßpunkt des zu untersuchenden Gebiets zugeführt werden. Das kann auf folgende Weisen erfolgen:
1. Man fährt mit dem Einzelsensor das Gebiet zeilenweise ab, wobei sich der Sensor nur horizontal bewegt. Das Verfahren liefert ein Rasterfeld mit den Daten über die Feldgrößen von Suchkörpem. Darüber hinaus können für die Meßgrößen, die zum gleichen Suchkörper gehören, mit trigonometrischen Verfahren Richtung und Entfernung zum Suchkörper bestimmt werden.
2. Man erweitert den Einzelsensor um zwei weitere Sensoren, wobei jeder Sensor mit seiner Ausrichtung in Richtung der drei Achsen des kartesischen Koordinatensystems ausgerichtet ist. Dann sind die Meßspannungen in den drei SQUID-Sensoren Funktionen der Winkel und haben die Information über die Richtung des Signals. So wird bei jedem Meßpunkt vorgegangen. Es ist auch möglich einen Einzelsensor durch seine Sensorfläche zu ersetzen, auf der zeilenmäßig SQUID-Sensoren angeordnet werden. Hierbei soll die Ausdehnung der Sensorfläche so groß sein, daß automatische Triangulationsrechnungen mit der geforderten Genauigkeit möglich sind, wozu Ausdehnungen von einigen Zentimetern bis zu etwa einem Meter erforderlich sein können. Die Belegungsdichte des SQUID-Feldes entscheidet über die Auflösung der Objekte.

Die zeilenmäßige Abtastung des Gebietes kann jetzt über eine Abtastung der Zeilenstruktur des SQUID-Feldes erfolgen. Auch hier könnten die Sensorflächen auf drei erweitert werden, die dann wiederum in Richtung der drei Achsen eines kartesischen Koordinatensystems ausgerichtet würden.

Für große Raum gebiete kann auch die Anordnung der SQUID-Felder auf einer Kugelfläche, z.B. einer Viertelkugel sinnvoll sein. Die Abtastung des Raumes könnte dann von räumlichen Polarkoordinaten ausgehen, die SQUID-Feldern auf den Teilkugeloberflächen sind in ihren Abständen gleichmäßig zu verteilen, wobei ihre Belegungsdichte wiederum entsprechend der angestrebten Auflösung vorgenommen wird. Die Meßdaten können dann, wie bei einem ebenen SQUID-Feldsystem, zeilenweise gelesen werden. Das Sensorsystem auf SQUID-Basis, das in ein angepaßtes Kühlsystem eingebaut sein muß, kann in einem transportfähigen Gerätebausatz montiert werden. Der Gerätebausatz weist eine eigene Erschütterungsisolierung sowie eine autonome Stromversorgung mit Batteriepufferung auf, die gegebenenfalls gegen Störungen gesichert ist. Statt auf einer Kugel können die SQUID-Systeme auch auf einem Rohrabschnitt angeordnet sein, z.B. zur Anwendung in der Medizin zur Aufnahme von Patienten.
Die Voraussetzungen für ein bildgesteuertes Verfahren zum Auffinden, Vermessen und Untersuchen von Objekten auf der Basis der Messung magnetischer Felder sind durch Angabe der Koordinaten der Meßpunkte im Raum und der dazugehörenden physikalischen Meßwerte erfüllt. Die Richtung der Felder und die Entfernung des Ursprunges der Felder, die von den Zielobjekten ausgehen, werden so genau wie mit keinem anderen Verfahren der Technik gemessen. Die Meßsignale der Zielobjekte können dann unmittelbar für die Signalanalyse und für das bildgebende Verfahren verwendet werden. Mit dem bildgebenden Verfahren wird auch eine Entfernungsbestimmung und eine allgemeine Vermessung der Zielobjekte verknüpft. Durch Einführung eines Koordinaten-Systems können die Strukturen dann maßstabsgetreu mit ihrer Orientierung im Raum abgebildet werden und erleichtern eine Identifizierung der Zielobjekte. Die digital anfallenden Signale werden durch eine supraleitende Digitaltechnik verarbeitet und ausgewertet.

Für medizinische Magnetfeldmessungen, beispielsweise am Herzen, kann die Feinstruktur innerhalb der Pulsintervalle, die Pulsbreite, das Pulswiederholintervall und Amplitudenschwankungen analysiert werden.

Mediziner könnten auch beispielsweise kleinste Narben am Herzen oder anderen Organen sehen. Brückenbauer könnten feinste Risse in ihren Konstruktionen aufspüren.

Der Aufbau einer RF-SQUID-Feld-Anlage unterscheidet sich von einer supraleitenden Kamera im wesentlichen dadurch, daß die Tunnelstapel mit Ringen versehen sind.

Um Winkel und Entfernung für jeden Meßpunkt bestimmen zu können, werden zwei jeweils senkrecht stehende RF-SQUID-Systeme zu einem SQUID-Feld zusammengeschaltet. Für die Winkelbestimmung reicht jeweils ein RF-SQUID aus. Je größer die Abstände zu den beiden Bezugs-RF-SQUID-Systemen sind, um so genauer werden die Winkel zu den einzelnen Meßpunkten erfaßt, und um so genauer sind die Entfernungen zu den Objekten.

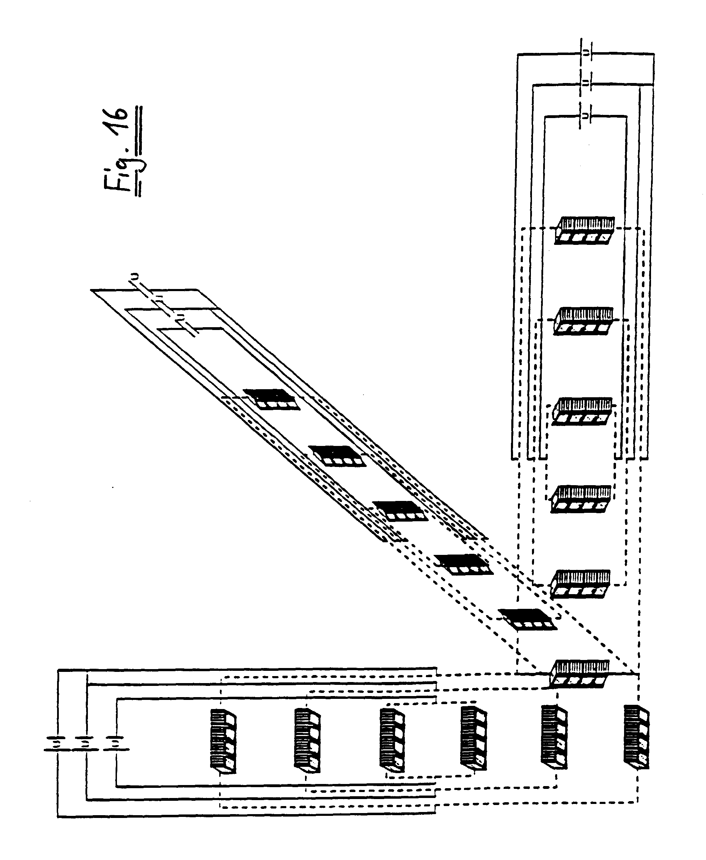

Der Aufbau eines DC-SQUID-Achsen-Feldes ist schematisch in Fig. 16 dargestellt. Eine DC-SQUID-Feld-Anlage mißt den Feldgradienten eines Gleichfeldes und ermöglicht unter anderem eine komfortable Bestimmung der Feldrichtung.

Mehrere ineinanderliegende DC-SQUID-Elemente bilden eine DC-SQUID-Achse. Für die drei Achsen Länge, Breite, Höhe wird je eine DC-SQUID-Achse vorgesehen. Das innere DC-SQUID-Paar innerhalb einer Achse hat die kleinste, das äußere DC-SQUID-Paar hat die größte Meßdistanz. Gemessen wird der Potentialunterschied der elektromagnetischen Feldstärke. Die Messung mit drei Achse ermöglicht es, einzelne Quellen zu identifizieren und ihre Entfernung zu bestimmen.

Eine supraleitungselektronische Apparatur einer DC-SQUID-Feld-Anlage besteht aus folgenden Baugruppen: einem Kryostaten, wobei der Dom für ganze Würfel gelten muß, drei DC-SQUID-Achsen auf einem Substratquader, einer elektronischen Steuerung zur Bedienung der Tunnelstapel-SQUID-Schaltungen, supraleitende Schirme gegen Störfelder und einem Montagehalter mit Versorgungsleitungen mit Steuer- und Signalleitungen.

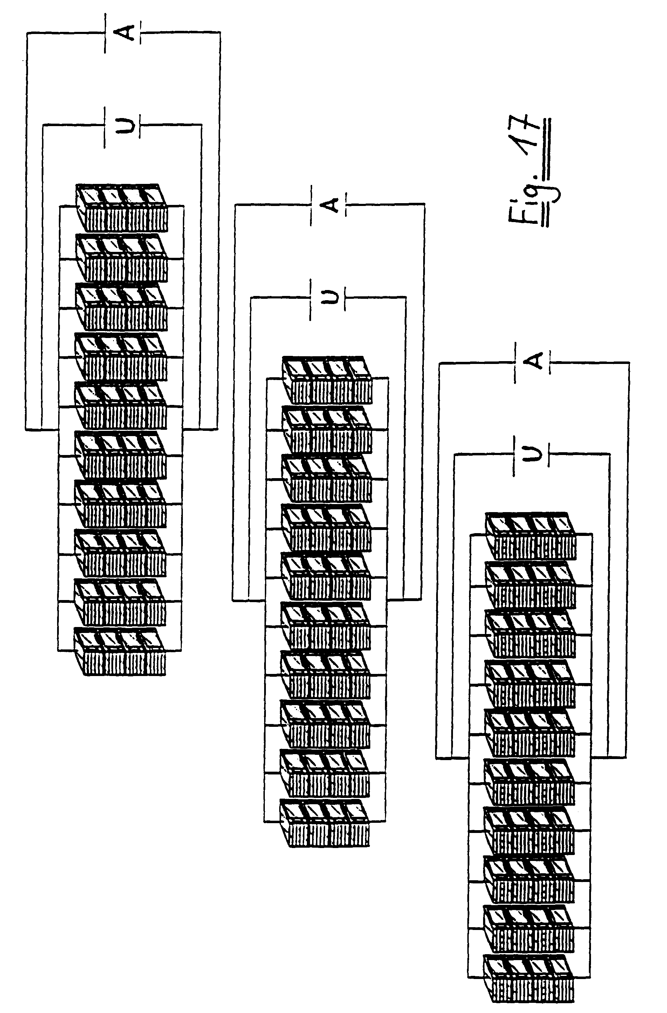

Der Aufbau eines quantenmechanischen Interferenz-Systems ist als Schaltschema in Fig. 17 dargestellt. Das quantenmechanische Interferenz-System besteht aus n parallel geschalteten Tunnelstapeln als Zeile. Dabei ist n jede ganze Zahl und kann mehr als tausend Stapel pro mm betragen. Eine 10 cm lange Zeile kann dann etwa eine Million Tunnelstapel enthalten. Diese Zeilen können mit Mikrometer-Abständen zu Tausenden wie ein optisches Gitter angeordnet werden und bilden dann das quantenmechanische Interferenz-System. Diese Interferenz-System ermöglicht die präzisesten Magnetfeldmessungen, die die Physik kennt.

Eine supraleitungselektronische Apparatur eines quantenmechanischen Interferenz-Systems besteht aus folgenden Baugruppen: einem Kryostaten, wobei der Dom für ganze Würfel gelten muß, einem bzw. mehreren Substratquader(n) mit einer zeilenweisen Anordnung von n Tunnelstapeln in Parallelschaltung wie in Fig. 17 dargestellt, eine elektronische Steuerung zur Bedienung der Tunnelstapel-lnterferenz-Schaltungen, supraleitende Schirme gegen Störfelder und Montagehaltern mit Versorgungsleitungen mit Steuer- und Signalleitungen.

## Patentansprüche

1. Supraleitendes Tunnelelement, das wenigstens eine erste Barriere aufweist, durch die ein Tunneln möglich ist, und Isolatoren, durch die ein Tunneln nicht erlaubt ist, mit einem ersten und vierten Supraleiter (S1, S4) als Steuerschichten sowie einem zweiten und dritten Supraleiter (S2, S3) als Tunnelschichten zwischen dem ersten und vierten Supraleiter, wobei zwischen den Tunnelschichten (S2, S3) eine erste Barriere (B) als Schicht steht und die Tunnelschichten (S2, S3) von den Steuerschichten (S1, S4) durch Isolatoren (I) getrennt sind, dadurch gekennzeichnet, daß zwischen der Barriere und den ihr jeweils benachbarten Tunnelschichten (S2, S3) jeweils eine sogenannte Proximity-Schicht (p1, p2) aus einem Normalleiter, Halbleiter oder Supraleiter mit gegenüber den Energielücken der Tunnelschichten (S2, S3) kleinerer Energielücke vorgesehen ist.

2. Tunnelelement nach Anspruch 1, dadurch gekennzeichnet, daß die als Steuerschichten dienenden ersten und vierten Supraleiter (S1, S4) die äußeren Schichten des Tunnelelementes bilden.

3. Tunnelelement nach Anspruch 1, dadurch gekennzeichnet, daß es beidseitig und symmetrisch zur Barriere (B) auf den jeweils außenliegenden ersten und vierten Supraleitern jeweils einen durch einen zusätzlichen Isolator (I) isolierten zusätzlichen nullten bzw. fünften Supraleiter (S0, S5) aufweist.

4. Tunnelelement nach Anspruch 2, dadurch gekennzeichnet, daß auf einer Seite anschließend an den äußeren vierten Supraleiter (S4) folgende zusätzliche Schichten in der angegebenen Reihenfolge vorgesehen sind: Isolator (I), fünfter Supraleiter (S5), Isolator (I), sechster Supraleiter (S4), zweite Barriere (B), siebter Supraleiter (S7).

5. Tunnelelement nach einem der Ansprüche 1 bis 4, dadurch gekennzeichnet, daß jeder der Supraleiter (S0 bis S7) individuelle supraleitende Anschlüsse aufweist.

6. Tunnelelement nach Anspruch 3, dadurch gekennzeichnet, daß die die beiden als Steuerschichten dienenden Supraleiter (S1, S4) umgebenden Supraleiter, d. h. der nullte Supraleiter (S0) mit dem zweiten Supraleiter (52) bzw. der dritte Supraleiter (S3) mit dem fünften Supraleiter (S5) miteinander über eine Kurzschlußbrücke verbunden und von der jeweiligen Steuerschicht (S1, S4) isoliert sind, wobei an die Eingänge der außenliegenden Supraleiter, d. h. des nullten und fünften Supraleiters (S0, S5) eine Arbeitsspannung anlegbar und an den Ausgängen ein Signalstrom abnehmbar ist.

7. Tunnelelement nach Anspruch 6, dadurch gekennzeichnet, daß die Kurzschlußbrücke supraleitend ist.

8. Tunnelelement nach Anspruch 4, dadurch gekennzeichnet, daß die der ersten Barriere (B) benachbarten zweiten und dritten Supraleiter (S2, S3) als supraleitende Tunnelschichten, der durch einen Isolator (I) isoliert neben einer der beiden Tunnel schichten äußere erste Supraleiter (S1) als Schreibleitung sowie der den zusätzlichen Schichten benachbarte vierte Supraleiter (S4) als Teil einer Tunnelschleife geschaltet ist und die der zusätzlichen zweiten Barriere (B) benachbarten zusätzlichen sechsten und siebten Supraleiter (S6, S7) mit der zusätzlichen zweiten Barriere einen Josephson-Kontakt bilden, der mit dem fünften, an das Tunnelelement nach Anspruch 1 anschließenden fünften Supraleiter (S5) als Leseleitung einen Stromkreis bildet.

9. Tunnelstapel, dadurch gekennzeichnet, daß er durch jeweils zwei oder mehrere Tunnelelemente gemäß einem der Ansprüche 1 bis 8 voneinander jeweils durch einen Isolator getrennt gebildet ist.

10. Tunnelstapel, dadurch gekennzeichnet, daß er durch jeweils zwei oder mehrere Tunnelelemente gemäß einem der Ansprüche 1 bis 8 voneinander jeweils durch eine Tunnelbarriere getrennt gebildet ist.

11. Tunnelstapel nach Anspruch 9 oder 10, dadurch gekennzeichnet, daß jedes Tunnelelement einzeln steuerbar und/oder schaltbar ist.

12. Tunnelstapel nach einem der Ansprüche 9 bis 11, dadurch gekennzeichnet, daß mindestens zwei Tunnelelemente gemeinsam schalt- und/oder steuerbar sind.

13. Verwendung von Tunnelelementen und/oder Tunnelstapeln nach einem der Ansprüche 1 bis 12 für eine digitale supraleitungselektronische Kamera.

14. Verwendung von Tunnelelementen und/oder Tunnelstapeln nach einem der Ansprüche 1 bis 12 für einen supraleitungselektronischen Strahler.

15. Verwendung von Tunnelelementen und/oder Tunnelstapeln nach einem der Ansprüche 1 bis 12 für eine supraleitungselektronische Vorrichtung zur Mikropositionierung mit Hilfe von stehenden elektromagnetischen Wellen.

16. Verwendung von Tunnelelementen und/oder Tunnelstapeln nach einem der Ansprüche 1 bis 12 für QuanteninterferenzGeräte.

## Claims

1. Superconducting tunnel element comprising at least one first barrier through which tunnelling is possible and insulators, through which tunnelling is not permitted, with a first and fourth superconductor (S1, S4) as control layers and a second and third superconductor (S2, S3) as tunnel layers between the first and fourth superconductor, a first barrier (B) being provided as a layer between the tunnel layers (S2 and S3) and the tunnel layers (S2, S3) being separated from the control layers (S1, S4) by insulators (I), characterised in that a respective so-called proximity layer (p1, p2) consisting of a normal conductor, semiconductor or superconductor with an energy gap which is smaller than the energy gaps of the tunnel layers (S2, S3) is provided between the barrier and the tunnel layers (S2, S3) adjacent to it in each case.

2. Tunnel element according to claim 1, characterised in that the first and fourth superconductor (S1, S4) serving as control layers form the outer layers of the tunnel element.

3. Tunnel element according to claim 1, characterised in that, on both sides of and symmetrically to the barrier (B) on the respective outer first and fourth superconductors, it comprises a respective additional zeroth and fifth superconductor (S0, S5) insulated by an additional insulator (I).

4. Tunnel element according to claim 2, characterised in that additional layers following the outer fourth superconductor (S4) are provided in the specified sequence on one side: insulator (I), fifth superconductor (S5), insulator (I), sixth superconductor (S4), second barrier (B), seventh superconductor (S7).

5. Tunnel element according to one of claims 1 to 4, characterised in that each of the superconductors (S0 to S7) has individual superconducting connections.

6. Tunnel element according to claim 3, characterised in that the superconductors surrounding the two superconductors (S1, S4) serving as control layers, i.e. the zeroth superconductor (S0) are connected to the second superconductor (S2) and the third superconductor (S3) to the fifth superconductor (S5) via a short-circuit bridge and are insulated from the respective control layer (S1, S4), wherein an operating voltage can be applied to the inputs of the outer superconductors, i.e. the zeroth and fifth superconductor (S0, S5), and a signal current can be removed from the outputs.

7. Tunnel element according to claim 6, characterised in that the short-circuit bridge is a superconductor.

8. Tunnel element according to claim 4, characterised in that the second and third superconductors (S2, S3) adjacent to the first barrier (B) are operated as superconducting tunnel layers, the outer first superconductor (S1) insulated by an insulator (I) next to one of the two tunnel layers is operated as a write line and the fourth superconductor (S4) adjacent to the additional layers is operated as part of a tunnel loop and the additional sixth and seventh superconductors (S6, S7) adjacent to the additional second barrier (B) form, with the additional second barrier, a Josephson contact which forms a circuit with the fifth superconductor (S5) adjoining the tunnel element according to claim 1 as read line.

9. Tunnel stack, characterised in that it is formed by two or more respective tunnel elements according to one of claims 1 to 8 separated from one another by a respective insulator.

10. Tunnel stack, characterised in that it is formed by two or more respective tunnel elements according to one of claims 1 to 8 separated from one another by a respective tunnel barrier.

11. Tunnel stack according to claim 9 or 10, characterised in that each tunnel element can be controlled and/or operated individually.

12. Tunnel stack according to one of claims 9 to 11, characterised in that at least two tunnel elements can be operated and/or controlled together.

13. Use of tunnel elements and/or tunnel stacks according to one of claims 1 to 12 for a digital superconducting electronic camera.

14. Use of tunnel elements and/or tunnel stacks according to one of claims 1 to 12 for a superconducting electronic radiator.

15. Use of tunnel elements and/or tunnel stacks according to one of claims 1 to 12 for a superconducting electronic device for micropositioning with the aid of stationary electromagnetic waves.

16. Use of tunnel elements and/or tunnel stacks according to one of claims 1 to 12 for quantum interference devices.

## Revendications

1. Elément tunnel supraconducteur, qui présente au moins une première barrière, à travers laquelle un effet tunnel est possible, et des isolateurs, à travers lesquels un effet tunnel n'est pas permis, comportant des premier et quatrième supraconducteurs (S1,S4) comme couches de commande, ainsi que des deuxième et troisième supraconducteurs (S2,S3), comme couches tunnels, entre les premier et quatrième supraconducteurs, entre les couches tunnels (S2,S3), une première barrière (B) est prévue comme couche et les couches tunnels (S2,S3) sont séparées des couches de commande (S1,S4) par des isolateurs (I),
caractérisé en ce que, entre la barrière et les couches tunnels (S2,S3) voisines, à chaque fois, de celle-ci, il est prévu, à chaque fois, une couche dite de proximité (p1, p2) constituée d'un conducteur normal, d'un semi-conducteur ou d'un supraconducteur ayant une lacune énergétique plus petite par rapport aux lacunes énergétiques des couches tunnels (S2,S3).

2. Elément tunnel selon la revendication 1,
caractérisé en ce que les premier et quatrième supraconducteurs (S1,S4), servant de couches de commande, forment les couches externes de l'élément tunnel.

3. Elément tunnel selon la revendication 1,
caractérisé en ce que qu'il présente, des deux côtés et symétriquement par rapport à la barrière (B), sur les premier et quatrième supraconducteurs à chaque fois externes, un supraconducteur respectif (S0,S5) zéro ou cinquième supplémentaire, isolé par un isolateur supplémentaire (I).

4. Elément tunnel selon la revendication 2,
caractérisé en ce que, sur un côté raccordé au quatrième supraconducteur externe (S4), les couches supplémentaires suivantes, dans la succession indiquée, sont prévues : isolateur (I), cinquième supraconducteur (S5), isolateur (I), sixième supraconducteur (S6), deuxième barrière (B), septième supraconducteur (S7).

5. Elément tunnel selon une des revendications 1 à 4,
caractérisé en ce que chacun des supraconducteurs (S0 à S7) présente des raccords supraconducteurs individuels.

6. Elément tunnel selon la revendication 3,
caractérisé en ce que les supraconducteurs entourant les deux supraconducteurs (S1,S4) servant de couches de commande, c'est-à-dire le supraconducteur zéro (S0) avec le deuxième supraconducteur (S2) ou le troisième supraconducteur (S3) avec le cinquième supraconducteur (S5), sont reliés ensemble par l'intermédiaire d'un élément de court-circuit et sont isolés de la couche de commande respective (S1,S4), une tension de travail pouvant être appliquée aux entrées des supraconducteurs externes, c'est-à-dire des supraconducteurs zéro et cinquième (S0,S5) et, aux sorties, un courant de signal peut être prélevé.

7. Elément tunnel selon la revendication 6,
caractérisé en ce que l'élément de court-circuit est supraconducteur.

8. Elément tunnel selon la revendication 4,
caractérisé en ce que les deuxième et troisième supraconducteurs (S2,S3) voisins de la première barrière (B) sont montés comme couches tunnels supraconductrices, le premier supraconducteur (S1) externe isolé par un isolateur (I) à côté d'une des deux couches tunnels est monté comme ligne d'écriture, et le quatrième supraconducteur (S4) voisin des couches supplémentaires est monté comme partie d'une boucle tunnel, et les sixième et septième supraconducteurs (S6,S7) supplémentaires voisins de la deuxième barrière supplémentaire (B) forment, avec la deuxième barrière supplémentaire, un contact de Josephson, qui forme, avec le cinquième supraconducteur (S5) raccordé à l'élément tunnel selon la revendication 1 comme ligne de lecture, un circuit.

9. Pile d'éléments tunnels,
caractérisée en ce qu'elle est formée par, à chaque fois, deux ou plusieurs éléments tunnels selon une des revendications 1 à 8, séparés à chaque fois les uns des autres par un isolateur.

10. Pile d'éléments tunnels,
caractérisée en ce qu'elle est formée, à chaque fois, par deux ou plusieurs éléments tunnels selon une des revendications 1 à 8, séparés à chaque fois les uns des autres par une barrière.

11. Pile d'éléments tunnels selon la revendication 9 ou 10,
caractérisée en ce que chaque élément tunnel peut être commuté et/ou commandé individuellement.

12. Pile d'éléments tunnels selon une des revendications 9 à 11,
caractérisée en ce qu'au moins deux éléments tunnels peuvent être commutés et/ou commandés en commun.

13. Utilisation d'éléments tunnels et/ou de piles d'éléments tunnels selon une des revendications 1 à 12 pour une caméra électronique numérique à supraconducteurs.

14. Utilisation d'éléments tunnels et/ou de piles d'éléments tunnels selon une des revendications 1 à 12 pour un émetteur électronique à supraconducteurs.

15. Utilisation d'éléments tunnels et/ou de piles d'éléments tunnels selon une des revendications 1 à 12 pour un dispositif électronique à supraconducteurs, pour le micropositionnement à l'aide d'ondes électromagnétiques stationnaires.

16. Utilisation d'éléments tunnels et/ou de piles d'éléments tunnels selon une des revendications 1 à 12 pour des appareils à interférences quantiques.
